(19) Europäisches Patentamt
European Patent Office
Office européen des brevets

(11) **EP 4 142 161 B1**

(12) **EUROPEAN PATENT SPECIFICATION**

(45) Date of publication and mention
of the grant of the patent:
**13.12.2023 Bulletin 2023/50**

(21) Application number: **21306162.5**

(22) Date of filing: **27.08.2021**

(51) International Patent Classification (IPC):
*H03M 13/11* (2006.01)    *H03M 13/13* (2006.01)
*H03M 13/29* (2006.01)

(52) Cooperative Patent Classification (CPC):
**H03M 13/1171; H03M 13/1191;** H03M 13/134;
H03M 13/2969

(54) **A METHOD FOR DECODING A CODEWORD ENCODED USING A NON-BINARY CODE, CORRESPONDING DEVICE AND COMPUTER PROGRAM**

VERFAHREN ZUR DECODIERUNG EINES MIT EINEM NICHT-BINÄREN CODE CODIERTEN CODEWORTES, ENTSPRECHENDE VORRICHTUNG UND COMPUTERPROGRAMM

PROCÉDÉ DE DÉCODAGE D'UN MOT CODÉ À L'AIDE D'UN CODE NON BINAIRE, DISPOSITIF CORRESPONDANT ET PROGRAMME INFORMATIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**01.03.2023 Bulletin 2023/09**

(73) Proprietor: **Universite De Bretagne Sud 56100 Lorient (FR)**

(72) Inventors:
• **BOUTILLON, Emmanuel**
  **56100 LORIENT (FR)**
• **JABOUR, Joseph**
  **MASTITA JBEIL (LB)**
• **MARCHAND, Cédric**
  **56530 QUEVEN (FR)**

(74) Representative: **Vidon Brevets & Stratégie 16B, rue de Jouanet BP 90333 35703 Rennes Cedex 7 (FR)**

(56) References cited:
**EP-A1- 3 316 486     EP-A1- 3 637 622**

• **JABOUR JOSEPH ET AL: "The Best, The Requested, and The Default Non-Binary LDPC Decoding Algorithm", PROC., IEEE 11TH INTERNATIONAL SYMPOSIUM ON TOPICS IN CODING (ISTC), [Online] 30 August 2021 (2021-08-30), pages 1-5, XP055879824, DOI: 10.1109/ISTC49272.2021.9594148 ISBN: 978-1-6654-0943-8 Retrieved from the Internet: URL:https://ieeexplore.ieee.org/stampPDF/g etPDF.jsp?tp=&arnumber=9594148&ref=aHR0c HM 6Ly9pZWVleHBsb3JlLmllZWUub3JnL2RvY3VtZ W50L zk1OTQxNDg=> [retrieved on 2022-01-17]**

**Description**

**1. Field of the disclosure**

The field of the disclosure is that of decoding of error correction code.
In particular, the disclosure provides a new technique for decoding a codeword obtained by implementing a non-binary error correction code.
The invention finds applications for instance in the field of wireless (DAB, DVB-T, WLAN, unguided optics, etc.) or wired (xDSL, PLC, optics, etc.) communications and memory storage.

**2. Background**

The error correcting codes conventionally used in digital communication systems are binary. In other words, the information symbols at the input of the encoder, and the redundancy symbols obtained at the output of the encoder, are binary elements, belonging to the Galois field GF(2).
In some cases, error correcting codes can also be non-binary, i.e. defined on a Galois field with a cardinal $q$ greater than 2, $GF(q)$.
For example, Non-Binary Low-Density Parity Check (NB-LDPC) codes are an extension of the Binary LDPC codes that were proposed by R. Gallager in 1963. NB-LDPC are defined by a set of parity check equations on $GF(q = 2^p)$ with $p > 1$. NB-LDPC codes outperform LDPC codes when short frames are used, since they have higher coding gain and lower error floor.
Non binary codes also include code over a set S with a group structure, as proposed for example by B. Shams, D. Declercq and V. Heinrich in "Non-binary split LDPC codes defined over finite groups" (6th International Symposium on Wireless Communication Systems, Siena, Italy, 2009, pp. 493-497).
In the background section below, we focus on code over GF($q$).
NB-LDPC code designed on $GF(q)$ is a linear block code defined by a sparse parity check matrix **H.** It has a block length of $N$ symbols (number of codeword symbols) and an information length of $K$ symbols (number of information symbols) on $GF(q)$ with a coding rate $r = K/N$. The number of redundant symbols added by the encoder is thus $M = N - K$.
The connections between the check nodes (CNs) and the variable nodes (VNs) are specified by the parity check matrix **H** which consists of $N - K$ rows and $N$ columns representing the total number of CNs and VNs respectively, where its element in row $i$ and column $j$ is denoted as $\mathbf{H}(i, j) = h_{i,j}$.

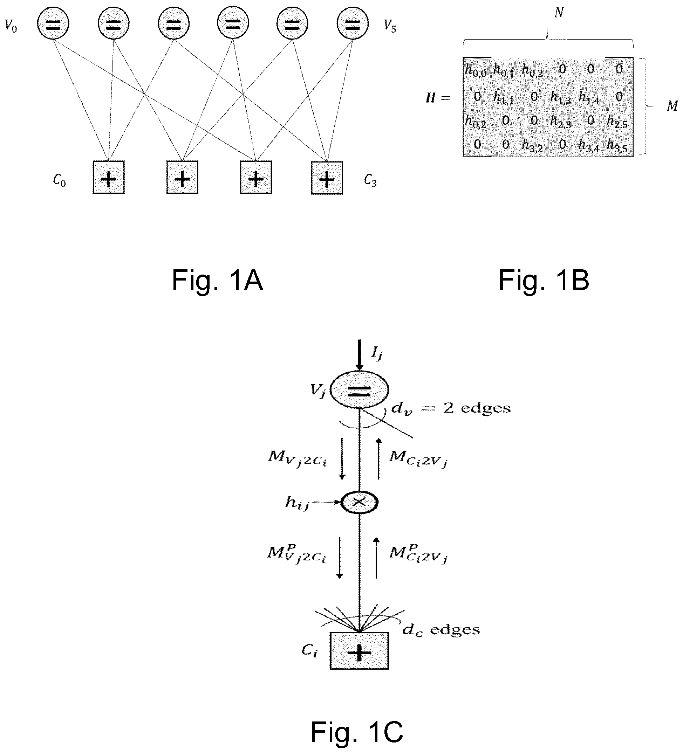

Figures 1A and 1B illustrate an example of Tanner Graph representation of a NB-LDPC code with the corresponding parity check matrix **H.** Figure 1C illustrate the connection or edge between a variable node $V_j$ and a check node $C_i$.
Let $\mathbf{x} = (x_1, x_2,...,x_N)$ be a codeword verifying $\mathbf{Hx} = 0$ transmitted through a noisy channel. For each transmitted GF symbol $x_j$, the receiver computes $I_j$, the Log-Likelihood Ratio (LLR) intrinsic vector defined as $I_j(a) = \log (P(x_j = \hat{a})/P(x_j = a))$, $a \in GF(q)$, with $\hat{a} = argmax\{P(x_j = a)\}$. Note that by construction, $I_j(a) = 0$ and $I_j(a) \geq 0$.
Let $M_{V_j2C_i}$ be a message sent from $VN_j$ to $CN_i$. The message vector is permuted by $h_{i,j}$ before being processed by the CN, and denoted as $M_{V_j2C_i}^P$ with $M_{V_j2C_i}^P(a) = M_{V_j2C_i}(h_{i,j}.a)$.

The CN generates a message $M_{C_i2V_j}^P$ sent from $C_i$ to $V_j$. The message $M_{C_i2V_j}^P$ is inversely permuted and inputted to the VN as $M_{C_i2V_j}$.

Lastly, the notations $\mathcal{N}(i)$ and $\mathcal{M}(j)$ represent the indices of the VN/CN connected to the $i^{th}/j^{th}$ CN/VN respectively.
The horizontal layered decoding scheduling according to an example of decoding algorithm is presented in Annex 1.
In this example, the degree $d_v$ of the variable node is assumed to be equal to 2. In the sequel, the check node index $i$ of $C_i$ is omitted, since using $d_v = 2$ suppresses the ambiguity on the check node index during the decoding process.
The decoding process starts with an initialization stage (line 3). Then, each decoding iteration is composed of the serial processing of the CN of the matrix (line 6). Each CN processing implies edge permutations and inverse edge permutations (lines 8 and 10). The CN processing (line 9) is presented by the Φ function that processes the $d_c$ incoming $M_{V_j2C}$, $j \in \mathcal{N}(i)$, messages, to generate $d_c$ $M_{C2V_j}$ messages.
The function Φ could be any of the different algorithms used for CN processing. After the CN processing, all VNs connected to the CN (line 12) are updated (lines 13, 14, 15, and 16). The third stage is the decision stage (line 20) which computes the tentative codeword and checks if the decoded message is a codeword (all parity constraints are satisfied).

Decoding NB-LDPC is thus significantly more complex than decoding binary LDPC.

In order to reduce the complexity of the NB-LDPC decoding, different approaches and schemes has been proposed and implemented, mainly focused on Check Nodes complexity reduction.

For example, the Extended Min-Sum (EMS) introduced by D. Declercq and M. Fossorier in "Decoding Algorithms for Non-Binary LDPC Codes Over GF(q)" (IEEE Transactions on Communications, vol. 55, no. 4, pp. 633-643, 2007) truncates the message vector between the Variable Nodes and the Check Nodes from $q$ down to $n_m$, where $n_m \ll q$, to reduce the computational load in the CN unit and hence reduces the hardware complexity.

Trellis Extended Min-Sum (T-EMS) decoders, described for example by E. Li, F. Garcia-Herrero, D. Declercq, K. Gunnam, J. O. Lacruz, and J. Valls, in "Low Latency T-EMS Decoder for Non-Binary LDPC codes" (Asilomar Conference on Signals, Systems and Computers, 2013, pp. 831-835), are based on the trellis representation of the input messages which allows high parallelism between the CN and VN.

In "Efficient T-EMS Based Decoding Algorithms for High-Order LDPC Codes" (IEEEAccess, vol. 7, pp. 50 980-50 992, 2019), J. Tian, S. Song, J. Lin, and Z. Wang present a threshold-based truncation decoding scheme (*TS-TEC-TEMS*) where two thresholds are used to truncate the incoming messages of the CN $M_{V2C}$ and the outgoing messages from the CN to the VN $M_{C2V}$.

V. Savin also proposes a Min-Max decoding algorithm in "Min-Max decoding for non binary LDPC codes" (IEEE International Symposium on Information Theory, 2008, pp. 960- 964.

Furthermore, patent publications EP 3 637 622 A1 and EP 3 316 486 A1 also disclose message-passing decoders of non-binary codes using truncated messages.

The function Φ used in the decoding algorithm illustrated in Annex 1 could be any of the different algorithms used for CN processing, such as the above-mentioned Min-Max, Extended Min-Sum or Trellis-EMS algorithm.

Although the above-mentioned algorithms allow reducing the complexity of the decoding, there is still a need for further reducing the decoding complexity, or for improving the performance of the decoder.

### 3. Summary of the invention

According to at least one embodiment, the disclosure thus provides a method for decoding a codeword, said codeword being obtained by implementing a code comprising at least one non-binary constraint node $C$ over a set $S$ of cardinality $q > 2$ defined from a parity check matrix $\mathbf{H_C}$ of the non-binary constraint node $C$ by the equation $\mathbf{H_C} \cdot (p_1(V_1), p_2(V_2), ..., p_{d_c}(V_{d_c}))^T = 0$, where $V_1$, $V_2$, ..., $V_{d_c}$ are a sub-set of non-binary variable nodes of the codeword implied in the non-binary constraint node $C$, with $d_c > 2$ the degree of connectivity of the non-binary constraint node $C$ and $p_1$, $p_2$, ... $p_{d_c}$ are permutations over the set $S$, wherein the decoding method implements, for at least one connection between the non-binary variable node $V_j$, $1 \le j \le d_c$, and the non-binary constraint node $C$, at least one decoding iteration comprising sending a message from the non-binary constraint node $C$ to the non-binary variable node $V_j$, said message comprising:

- $n_R$ measures of reliability obtained for $n_R$ candidate symbols selected by the non-binary variable node $V_j$ or by a first compression block implemented between the non-binary variable node $V_j$ and the non-binary constraint node $C$, said $n_R$ candidate symbols being denoted $n_R$ requested symbols,
- $n_B$ measures of reliability obtained for $n_B$ candidate symbols selected by the non-binary constraint node $C$ or by a second compression block implemented between the non-binary constraint node $C$ and the non-binary variable node $V_j$, said $n_B$ candidate symbols being denoted $n_B$ best symbols,

with $1 \le n_B < q$, $1 \le n_R < q$ and $n_R + n_B < q$.

According to such embodiment, the message sent by the non-binary constraint node to the variable node comprises both measures of reliability obtained for the $n_B$ best symbols, that are selected by the non-binary constraint node (where the non-binary constraint node can be for example a parity check node, or a sub-code, for example a convolutional code), and measures of reliability obtained for the $n_R$ requested symbols, that are requested by the variable node.

The proposed algorithm is thus based on requesting measures of reliability associated with relevant symbols from the non-binary constraint node such that the measures of reliability associated with the requested symbols (for example LLR) can be concatenated with the measures of reliability associated with the $n_B$ best symbols, and sent back to the variable node.

In this way, the proposed algorithm can reduce complexity of the non-binary error correction code by reducing the communication load between the variable nodes and the non-binary constraint nodes. It indeed allows a variable node to request the reliability associated with specific symbols to be included in the extrinsic message sent by the non-binary constraint node. It can be noted that the proposed algorithm is independent of the non-binary constraint node / variable node processing.

In particular, reducing the communication load can reduce at least one of the memory resources allocated for the messages exchanged between the variable nodes and the non-binary constraint nodes, the sorting process, the permutation / inverse permutation processes, and/or other hardware requirements.

According at least one embodiment, the proposed algorithm allows decreasing the size of the exchanged messages, which reduces the complexity and latency of the decoder, without significant performance degradation. In addition, decreasing the message size allows increasing the throughput in serial architectures and reduces the routing congestion in highly parallel architectures.

In particular, the requested candidates can enhance code convergence, with lower candidates propagating to/from a variable node, by increasing the probability that the symbol reliability of the $j^{th}$ transmitted symbol belongs effectively to the message sent from the non-binary constraint node $C$ to the variable node $V_j$.

According to at least one embodiment, said $n_R$ requested symbols are selected as the $n_R$ most reliable symbols from at least one of:

- an intrinsic message obtained from the channel observation,
- an *a posteriori* probability message,
- a message from the variable node $V_j$ to the non-binary constraint node $C$.

In this way, the variable node can request a new measure of reliability of a symbol (the reliability being determined by the non-binary constraint node) for a symbol which is for example already considered by the variable node as reliable. The proposed method can thus increase the convergence of the code by increasing the probability that the transmitted symbol belongs to the set of the most reliable candidates.

In particular, one symbol of the $n_R$ requested symbol can be obtained from the intrinsic message, another symbol can be obtained from the *a posteriori* probability message, yet another symbol can be obtained from the message from the variable node $V_j$ to the non-binary constraint node, etc.

As an alternative, all the $n_R$ requested symbols are obtained from the same message.

According to at least one embodiment, said $n_B$ best symbols are selected as the $n_B$ most reliable symbols from an extrinsic message issued by the non-binary constraint node.

It can be noted that some symbols can be both selected as requested symbols and best symbols.

According to at least one embodiment, said message sent from the non-binary constraint node $C$ to the variable node $V_j$ also comprises the $n_B$ best symbols.

In this way, the message sent by the non-binary constraint node to the variable node comprises measures of reliability associated with the $n_B$ best symbols, selected by the non-binary constraint node, measures of reliability associated with the $n_R$ requested symbols, requested by the variable node, as well as the $n_B$ best symbols. There is no need to send the $n_R$ requested symbols to the variable node $V_j$, as they are already known by the variable node $V_j$.

According to at least one embodiment, said at least one decoding iteration further comprises transmitting a message from the variable node $V_j$ to the non-binary constraint node $C$, comprising:

- generating a message $M_{V_j2C}$ comprising measures of reliability obtained for the q candidate symbols of the set $S$ (for example a Galois Field GF(q)),
- selecting from the message $M_{V_j2C}$, by a first compression block $\Omega$, $n_{vc}$ candidate symbols (for example the most reliable) and generating a message $\Omega(M_{V_j2C})$ comprising the $n_{vc}$ symbols and the measures of reliability obtained for said $n_{vc}$ symbols,
- selecting, by the first compression block $\Omega$, the $n_R$ requested symbols from the message $M_{V_j2C}$, and sending a message $M^{R,\oplus}$ to a second decompression block $\Gamma^{-1}$, comprising the $n_R$ requested symbols,
- permuting the $n_{vc}$ symbols of the message $\Omega(M_{V_j2C})$, delivering a message $\Omega\left(M_{V_j2C}^P\right)$, and the $n_R$ requested symbols, delivering a message $M^{P,R,\oplus}$,
- reconstructing, by a first decompression block $\Omega^{-1}$, a message $\Omega^{-1}\left(\Omega\left(M_{V_j2C}^P\right)\right)$ comprising the $n_{vc}$ symbols, the measures of reliability obtained for said $n_{vc}$ symbols, remaining $q - n_{vc}$ symbols, and measures of reliability set to a default value for the remaining $q - n_{vc}$ symbols,
- transmitting to a second compression block $\Gamma$ the message $M^{P,R,\oplus}$, comprising the $n_R$ requested symbols after permutation.

Such embodiment can be implemented when the compression / decompression of the message is not directly implemented by the variable node / non-binary constraint node.

According to at least one embodiment, said message sent from the non-binary constraint node $C$ to the variable node $V_j$ is sent when the non-binary constraint node $C$ has received messages $M_{V2C}^P$ from all the variable nodes connected to the non-binary constraint node $C$, and is obtained from:

- generating, from the $M_{Vk2C}^P$ received messages, $k \neq j$, a message $M_{C2Vj}^P$, comprising measures of reliability obtained for the q candidate symbols of the set $S$,

- selecting from the message $M_{C2Vj}^P$, by the second compression block $\Gamma$, $n_B$ best symbols (for example the most reliable) and generating a message $M_{C2Vj}^{P,B}$ comprising the $n_B$ best symbols and the measures of reliability obtained for said $n_B$ best symbols,

- obtaining, from the message $M_{C2Vj}^P$, the measures of reliability of the $n_R$ requested symbols after permutation received by the second compression block $\Gamma$ in the message $M^{P,R,\oplus}$,

- generating a message $\Gamma\left(M_{C2Vj}^P\right)$ comprising the message $M_{C2Vj}^{P,B}$ and the measures of reliability of the $n_R$ requested symbols after permutation,

- inversely permuting the $n_B$ best symbols of the message $\Gamma\left(M_{C2Vj}^P\right)$, delivering a message $\Gamma(M_{C2V_j})$,

- reconstructing, by the second decompression block $\Gamma^{-1}$, a message $\Gamma^{-1}(\Gamma(M_{C2V_j}))$ comprising the $n_B$ best symbols, the measures of reliability obtained for said $n_B$ best symbols, the $n_R$ requested symbols, the measures of reliability obtained for said $n_R$ requested symbols, $n_D$ remaining symbols and measures of reliability obtained for said $n_D$ remaining symbols set to a default value $S_D$.

Such embodiment can be implemented when the compression / decompression of the message is not directly implemented by the non-binary constraint node / variable node.

In particular, the measure of reliability associated with at least one of said $n_R$ requested symbols can be set to a default value $S_R$ when said measure of reliability is above a threshold.

According to at least one embodiment, said at least one non-binary constraint node implements a decoding function belonging to the group comprising:

- a Min-Max function,
- an Extended MinSum (EMS) function,
- a Trellis-Extended MinSum (T-EMS) function,
- a threshold-based truncation decoding (TS-TEC-TEMS) function,
- a Belief Propagation (BP) function,
- a Fourier domain implementation of a BP function, such as for example disclosed in "Fast Decoding Algorithm for LDPC over GF(2q)", L. Barnault and D. Declercq (The Proc. 2003 Inform. Theory Workshop, Paris, France, pp. 70-73, Mar. 2003),
- a Forward/Backward function,
- etc.

The proposed algorithm can thus be used with any of the different algorithms used for CN processing, such as those disclosed in the background section for example. In particular, it can be used with sub-optimal algorithm, such as the EMS, or with optimal algorithm, such as the BP.

Decoding functions such as those cited above can be used by a parity check node, when the code is for example a LDPC or a polar code.

Decoding functions such as BP, Fourier domain implementation of a BP, Forward/Backward can be used by a sub-code, when the code is for example a turbo-code.

It can also be used with any variable/non-binary constraint node degree of connectivity $d_v$ and $d_c$ respectively.

According to at least one embodiment, the code belongs to the group comprising:

- a LDPC code,
- a polar code,

- a turbo-code.

For example, the non-binary constraint node is a parity check node with a degree of connectivity $d_v$ given as $p_1(V_1) + p_2(V_2) + \cdots + p_{d_c}(V_{d_c}) = 0$ over the set S when the code is a LDPC or a polar code, or a convolutional code when the code is a turbo code.

According to at least one embodiment, the message sent from the non-binary constraint node $C$ to the variable node $V_j$ comprises a default symbol reliability associated with $n_D$ remaining symbols that do not belong to the set of $n_B$ best symbols nor to the set of $n_R$ requested symbols.

In this way, the message sent by the non-binary constraint node to the variable node comprises measures of reliability obtained for the $n_B$ best symbols, which are selected by the non-binary constraint node, measures of reliability obtained for the $n_R$ requested symbols, which are requested by the variable node, and measures of reliability obtained for the $n_D$ remaining symbols, that can be set to a default value $S_D$. There is no need to send the $n_D$ remaining symbols to the variable node $V_j$, as they can be deduced by the variable node $V_j$.

For example, the default value can be computed in the decompression block of the message sent from the non-binary constraint node to the variable node using the $n_R$ measures of reliability and $n_B$ measures of reliability.

In particular, at least one measure of reliability obtained for one of said $n_R$ requested symbols and/or at least one measure of reliability obtained for one of said $n_D$ remaining symbols can be set to a default value.

According to at least one embodiment, the message sent from the non-binary constraint node $C$ to the variable node $V_j$ comprises at most $n_B + n_R + 1$ measures of reliabilities.

The disclosure also relates to a corresponding device for decoding a codeword.

Such a device for decoding a codeword is in particular adapted to implement the decoding method described above. It is, for example, a non-binary LDPC decoder, turbo-decoder, or polar code decoder. This device could of course include the various features relating to the decoding method according to the invention, which can be combined or taken in isolation. Thus, the features and advantages of this device are the same as those of the method described above. Therefore, they are not further detailed.

The invention also relates to one or more computer programs including instructions for the implementation of a method for decoding a codeword as described above when this or these programs are executed by at least one processor.

The invention also relates to an information medium readable by a computer, and including instructions of a computer program as mentioned above.

## 4. List of figures

Other features and advantages of the invention will emerge more clearly upon reading the following description of a particular embodiment, given by way of simple illustrative and nonlimiting example, and the appended drawings, among which:

- Figures 1A and 1B illustrate an example of Tanner Graph representation of a NB-LDPC code;
- Figure 1C illustrate the connection or edge between a variable node and a check node;
- Figure 2 illustrates the main step implemented by a method for decoding a codeword according to at least one embodiment;
- Figures 3A and 3B illustrate an embodiment of the "BRD" algorithm according to the disclosure, where the compression / decompression functions are not implemented by the variable/check nodes;
- Figure 4 gives an example of an Elementary Check Node architecture for the EMS-based BRD decoder;
- Figure 5 illustrates how to find the requested symbols in a $n_m \times n_m$ matrix;
- Figure 6 illustrates the probability $P(x_j \in M_{C2V_j})$ that the transmitted symbol $x_j$ belongs effectively to the message $M_{C2V_j}$ for different decoding algorithms;
- Figure 7 shows the impact of the decoder parameters on the Frame Error Rate (FER) for different decoding algorithms;
- Figure 8 shows simulation results for different sizes of code and for different decoding algorithms;
- Figure 9 illustrates a non-binary turbo-code represented as a bipartite graph;
- Figure 10 illustrates the kernel of a polar code;
- Figure 11 shows the simplified structure of a device for decoding a codeword according to one embodiment of the invention

## 5. Description of at least one embodiment

### 5.1 General principle

The disclosure is based on the idea of identifying at least one symbol, denoted as requested symbol, for which a variable node (VN) wishes to obtain a measure of reliability from a non-binary constraint node (CN).

The non-binary constraint node thus has a knowledge of the information requested by the variable node, and does not select "blindly" the symbols and associated measures of reliability that have to be sent to the variable node.

In other words, the requested symbols are the symbols sent by the VN to the CN such that their measures of reliability (LLRs for example) are obtained by the CN (using any CN processing algorithm) and sent to the VN.

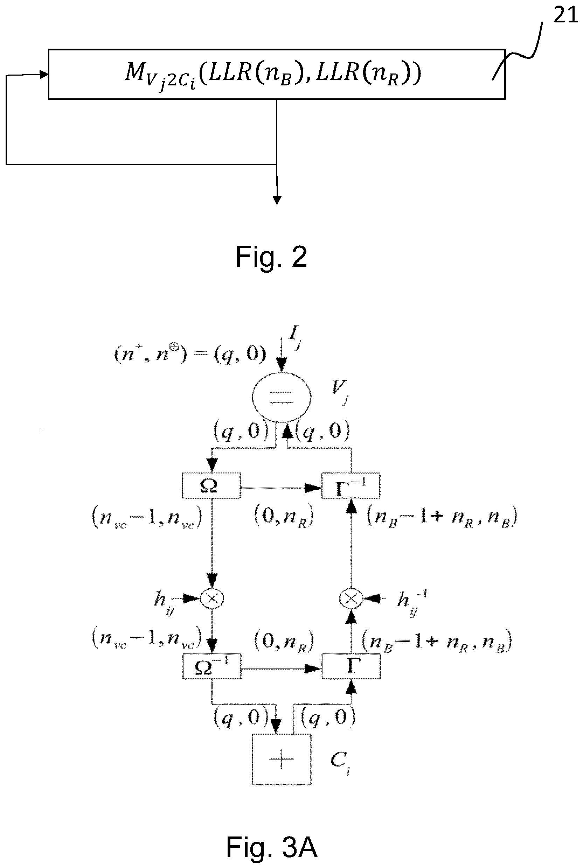

Figure 2 illustrates the main step implemented by a method for decoding a codeword according to at least one embodiment.

We consider a non-binary error correction code comprising at least one non-binary constraint node $C$ over a set $S$ of cardinality $q > 2$ defined from a parity check matrix $\mathbf{H_C}$ of the non-binary constraint node $C$ by the equation $H_C \cdot (p_1(V_1), p_2(V_2), ..., p_{d_c}(V_{d_c}))^T = 0$, where $V_1, V_2, ..., V_{d_c}$ are a sub-set of non-binary variable nodes of the codeword implied in the non-binary constraint node $C$, with $d_c > 2$ the degree of connectivity of the non-binary constraint node $C$ and $p_1, p_2, ...p_{d_c}$ are permutations over the set $S$.

For at least one connection between a non-binary variable node $V_j$ from the set of variable nodes $\{V_1, V_2, ..., V_{d_c}\}$ and the non-binary constraint node $C$ said method implements at least one decoding iteration comprising sending (21) a message from the non-binary constraint node $C$ to the variable node $V_j$, said message comprising:

- $n_R$ measures of reliability obtained for $n_R$ candidate symbols selected by the variable node $V_j$ or by a first compression block implemented between the variable node $V_j$ and the non-binary constraint node $C$, said $n_R$ candidate symbols being denoted $n_R$ requested symbols,
- $n_B$ measures of reliability obtained for $n_B$ candidate symbols selected by the non-binary constraint node $C$ or by a second compression block implemented between the non-binary constraint node $C$ and the variable node $V_j$, said $n_B$ candidate symbols being denoted $n_B$ best symbols,

with $1 \leq n_B < q$, $1 \leq n_R < q$ and $n_R + n_B < q$.

For example, the $n_R$ requested symbols (for which a measure of reliability is requested by the variable node) are the $n_R$ most reliable symbols among the $q$ symbols of the set (for example GF(q)) of the variable node to the non-binary constraint node message $M_{V2C}$, since it achieved the best performance in terms of Frame Error Rate (FER). The requested symbols can, as an alternative, be obtained from the intrinsic information $I_j(a)$ or the "a posteriori probability" $APP_j[a]$.

The $n_R$ requested symbols can thus be some of the $n_R$ most reliable intrinsic symbols and/or some of the $n_R$ most reliable symbols of the APP message and/or some of the $n_R$ most reliable symbols of the message $M_{V2C}$.

Once the $n_R$ requested symbols have been selected, the non-binary constraint node is informed and can determine the measures of reliability associated with said $n_R$ requested symbols, using any techniques classically used for CN processing, such as those disclosed in the background section for example. For example, the measures of reliability are Log-Likelihood Ratio.

The variable node can thus obtain, from the non-binary constraint node, measures of reliability associated with said $n_R$ requested symbols.

The non-binary constraint node can also select $n_B$ best symbols of the set, for example the $n_B$ most reliable symbols among the $q$ symbols of the set, from the extrinsic information. The number of requested symbols $n_R$ and of best symbols $n_B$ is independent. As a consequence, the number of requested symbols $n_R$ can be less than, greater than, or equal to the number of best symbols $n_B$. If a symbol appears twice, one as a requested symbol and one as a best symbol, the measure of reliability associated with this symbol can only be transmitted once to the variable node.

The variable node can thus obtain, from the non-binary constraint node, measures of reliability associated with said $n_B$ best symbols.

According to at least one embodiment, the message can also comprise at least one remaining symbol reliability obtained for the $n_D$ remaining symbols that do not belong to the set of $n_B$ best symbols nor to the set of $n_R$ requested symbols.

A default value can be set to the measures of reliability associated with the remaining symbols.

For example, the default value can be determined by the non-binary constraint node and send explicitly within the message from the non-binary constraint node $C$ to the variable node $V_j$. The default value can also be determined from the $n_R$ measures of reliability and $n_B$ measures of reliability. Other methods can be proposed to determine the default value.

The variable node can thus obtain information for all the $q$ symbols of the set. For example, the set can be a Galois field GF(q).

The proposed algorithm can be called the Best, the Requested and the Default, or BRD algorithm.

At least one iteration of decoding can be implemented. At each iteration, the set of $n_R$ requested symbols / $n_B$ best symbols can be changed. The number $n_R$ of requested symbols / $n_B$ of best symbols can also change at each iteration.

## 5.2 Non-binary LDPC

We describe hereafter an example of a method for decoding a non-binary LDPC according to at least one embodiment. In this case, the non-binary constraint nodes are parity check nodes. However, as already mentioned, the disclosure is not limited to this kind of error correction code, and the proposed method can be implemented for the decoding of other error correction codes, such as turbo codes or polar codes for example.

In the example below, we also consider a non-binary error correction code designed on a Galois Field GF(q), with $q > 2$. However, the proposed method could also be extended from a NB-LDPC code on a Galois Field to any NB-LDPC code on a group, like the one proposed in the previously cited document "Non-binary split LDPC codes defined over finite groups".

The edge permutation can also be generalized from a permutation defined by a constant GF multiplication to any permutation.

As already mentioned, the proposed algorithm is a generic decoding algorithm used with any check node processing algorithm, such as for example the EMS algorithm, the T-EMS algorithm, the TS-TEC-TEMS algorithm, the Min-Max algorithm. It can also be used for any variable/check node degree of connectivity $d_v$ and $d_c$ respectively. The algorithm allows the variable node to request the reliability associated with specific symbols such that the symbols' reliability are sent back by the check node.

According to at least one embodiment, the measure of reliability of the requested symbols, for example LLR values, are concatenated with the most reliable extrinsic elements obtained at the check node and sent all together to the variable node. The $M_{C2V}$ message can thus be considered as a union of three subsets:

- a first set $M_{C2V}^B$ , which comprises $n_B$ measures of reliability obtained for $n_B$ candidate symbols, for example the $n_B$ best candidates generated by the check node (the $n_B$ candidate symbols being denoted best symbols). Such $n_B$ best symbols and/or measures of reliability can be obtained, for example, using the classical EMS algorithm;

- a second set $M_{C2V}^R$ , which comprises $n_R$ measures of reliability obtained for $n_R$ candidate symbols that are requested by the variable node (the $n_R$ candidate symbols being denoted requested symbols);

- eventually a third set $M_{C2V}^D$ , which comprises a measure of reliability associated with the remaining candidate symbols (i.e. the candidate symbols that are neither best symbols, nor requested symbols). The measure of reliability of the remaining symbols can be set to a default value $S_D$.

This concatenation contributes to increasing the probability of the correct symbol $x_j$ being propagating from/to the CN, hence, increasing the decoding performance of the decoder.

In the sequel, an exponent $A^+$ indicates the LLR values, and $A^\oplus$ indicates the values of the symbols (for example GF values) of the set A.

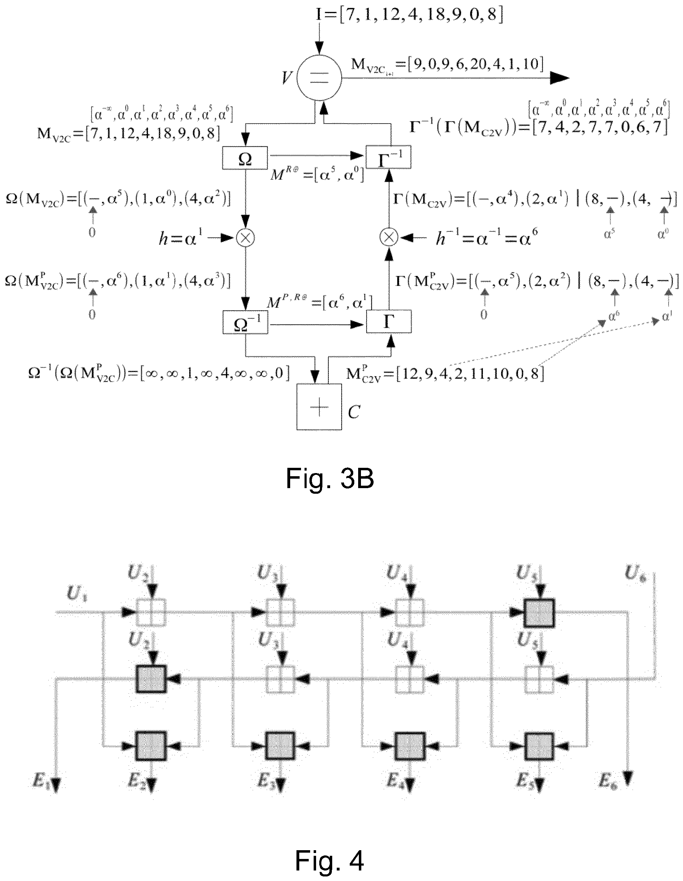

Figures 3A and 3B illustrate an embodiment of the BRD algorithm, where the compression / decompression functions are not implemented by the variable/check nodes. In other words, a message $M_{V2C}$ output by the variable node is a vector of size q, and a message $M_{C2V}$ output by the check node is a vector of size q.

Figure 3A shows the size of the messages in brackets, with the first element corresponding to the number of measures of reliability and the second element corresponding to the number of candidate symbols. Figure 3B shows an example on GF(8).

For a variable node $V_j$, the intrinsic message $I_j$ comprises q values of LLR. In the example illustrated in Figure 3B, the intrinsic message $I_j$ is given as $I_j = [7,1,12,4,18,9,0,9]$.

In a first step, a message $M_{Vj2Ci}$ comprising measures of reliability associated with the q candidate symbols of GF(q) is generated. For the first iteration, the message $M_{Vj2Ci}$ is set to $I_j$: $M_{Vj2Ci} = I_j$. The position of each LLR values gives implicitly the associated candidate symbol value.

*A. Compression and Decompression of $M_{Vj2Ci}$ message*

A first compression block $\Omega$ generates a message $\Omega(M_{Vj2Ci})$ from the message $M_{Vj2Ci}$, by selecting $n_{vc}$ candidate symbols of GF(q). For example, the first compression block $\Omega$ selects the $n_{vc}$ smallest LLRs and their associated GF

value. The message $\Omega(M_{Vj2Ci})$ thus comprises the $n_{vc}$ symbols and the measures of reliability associated with said $n_{vc}$ symbols.

Since after normalization, the smallest LLR is always equal to 0, the message $\Omega(M_{Vj2Ci})$ is composed of $(n^{+}, n^{\oplus}) = (n_{vc} - 1, n_{vc})$ LLR and GF values, respectively.

In the example illustrated in Figure 3B, with $n_{vc} = 3$, the first compression block $\Omega$ extracts the three smallest LLR of the message $M_{Vj2Ci}$ to generate the message $\Omega(M_{Vj2Ci})$ comprising three pairs: $[(-, \alpha^5), (1, \alpha^0), (4, \alpha^2)]$. After normalization, since the LLR of the first pair is always equal to 0, it could be omitted. The message $\Omega(M_{Vj2Ci})$ thus contains two LLR and three GF symbols.

The first compression block $\Omega$ also selects $n_R$ requested symbols, from the message $M_{Vj2Ci}$, and sends a message $M^{R,\oplus}$ to a second decompression block $\Gamma^{-1}$, comprising the $n_R$ requested symbols, for example the GF values of the first $n_R$ pairs of the message $\Omega(M_{Vj2Ci})$

In the example illustrated in Figure 3B, with $n_R = 2$, the first compression block $\Omega$ extracts the two GF symbols of the most reliable candidates to generate the message $M^{R,\oplus}$ comprising two GF symbols: $(\alpha^5, \alpha^0)$.

The $n_{vc}$ symbols of the message $\Omega(M_{Vj2Ci})$ and the $n_R$ requested symbols are then permuted. For example, the edge multiplicative factor $h_{i,j}$ is applied to each GF element of the message $\Omega(M_{Vj2Ci})$ to generate a message $\Omega\left(M^{P}_{V_j2C_i}\right)$, and the edge multiplicative factor $h_{ij}$ is applied to each GF element of the message $M^{R,\oplus}$ to generate a message $M^{P,R,\oplus}$.

In the example illustrated in Figure 3B, with $h_{i,j} = \alpha^1$, the GF values of the message $\Omega(M_{Vj2Ci})$ are multiplied by $h_{i,j} = \alpha^1$, generating a message $\Omega\left(M^{P}_{V_j2C_i}\right) = [(-, \alpha^6), (1, \alpha^1), (4, \alpha^3)]$. The GF values of the message $M^{R,\oplus}$ are also multiplied by $h_{i,j} = \alpha^1$, generating a message $M^{P,R,\oplus} = (\alpha^6, \alpha^1)$.

A first decompression block $\Omega^{-1}$ then decompresses the message $\Omega\left(M^{P}_{V_j2C_i}\right)$ back to a message of size q, by setting the $n_{vc}$ GF values of $\Omega\left(M^{P}_{V_j2C_i}\right)$ with their corresponding LLRs and by setting a default value (for example a very high value, denoted infinity) to the remaining GF values. A message $\Omega^{-1}\left(\Omega\left(M^{P}_{V_j2C_i}\right)\right)$ comprising the $n_{vc}$ symbols, the measures of reliability associated with said $n_{vc}$ symbols, remaining $q - n_{vc}$ symbols, and measures of reliability set to a default value for the remaining $q - n_{vc}$ symbols.

In the example illustrated in Figure 3B, the first decompression block $\Omega^{-1}$ generates the input check node $\Omega^{-1}\left(\Omega\left(M^{P}_{V_j2C_i}\right)\right)$ by assigning the LLRs 0, 1 and 4 in positions $\alpha^6, \alpha^1, \alpha^3$ respectively, and infinite values otherwise.

Moreover, the first decompression block $\Omega^{-1}$ can also transmit to a second compression block $\Gamma$ the message $M^{P,R,\oplus}$, comprising the $n_R$ requested symbols after permutation. It is for example composed of the $n_R$ most reliable GF symbols in $\Omega\left(M^{P}_{V_j2C_i}\right)$.

In the example illustrated in Figure 3B, the first decompression block $\Omega^{-1}$ transmit to the second compression block $\Gamma$ the two requested symbols, in the message $M^{P,R,\oplus} = (\alpha^6, \alpha^1)$.

It could be noted that when the EMS algorithm is used for the check node processing, the first compression block $\Omega$ and the first decompression block $\Omega^{-1}$ can be bypassed, since EMS, by construction, used truncated messages.

The proposed compression of exchange messages is however fully compatible with the EMS message representation.

*B. Compression and Decompression of $M_{Ci2Vj}$ message*

When the check node $C_i$ has received messages $M^{P}_{V_j2C_i}$ from all the variable nodes connected to the check node $C_i$, the check node processes the $M^{P}_{V_j2C_i}$ using any processing algorithm, such as for example EMS or T-EMS.

The check node can thus generate, from the $M^P_{V_k2C_i}$ received messages, $k \neq j$, a message $M^P_{C_i2V_j}$, comprising measures of reliability associated with the q candidate symbols of GF(q).

In the example illustrated in Figure 3B, the check node generates the message $M^P_{C_i2V_j} =$ [12,9,4,2,4,10,0,8].

The message $M^P_{C_i2V_j}$ can be truncated by the second compression block $\Gamma$ in two steps.

Firstly, the second compression block $\Gamma$ selects, from the message $M^P_{C_i2V_j}$, $n_B$ best symbols of GF(q) and generates a message $M^{P,B}_{C_i2V_j}$ comprising the $n_B$ best symbols and the measures of reliability associated with said $n_B$ best symbols. For example, the second compression block $\Gamma$ selects the $n_B$ most reliable candidates to generate the message $M^{P,B}_{C_i2V_j}$ of size $(n^+, n^\oplus) = (n_B - 1, n_B)$.

Secondly, the measures of reliability of the $n_R$ requested symbols after permutation, received by the second compression block $\Gamma$ in the message $M^{P,R,\oplus}$, are obtained from the message $M^P_{C_i2V_j}$. For example, the LLR of the $n_R$ requested symbols of the message $M^{P,R,\oplus}$ are extracted from $M^{P,B}_{C_i2V_j}$.

A message $\Gamma\left(M^P_{C_i2V_j}\right)$ comprising the message $M^{P,B}_{C_i2V_j}$ and the measures of reliability of the $n_R$ requested symbols after permutation can thus be generated, for example by concatenating the message $M^{P,B}_{C_i2V_j}$ and the LLR of the $n_R$ requested symbols of the message $M^{P,R,\oplus}$. The size of the message $\Gamma\left(M^P_{C_i2V_j}\right)$ is $(n^+, n^\oplus) = (n_B + n_R - 1, n_B)$.

In the example illustrated in Figure 3B, with $n_B = 2$, the second compression block $\Gamma$ selects the most reliable $n_B = 2$ candidates from the message $M^P_{C_i2V_j}$ and it concatenates the LLR of the $n_R$ requested candidates of the message $M^{P,R,\oplus}$. Thus $\Gamma\left(M^P_{C_i2V_j}\right) = M^B_{C_i2V_j} \cup M^R_{C_i2V_j} =$ [(-, $\alpha^5$), (2, $\alpha^2$)|(8, -),(2, -)].

The $n_B$ best symbols of the message $\Gamma\left(M^P_{C_i2V_j}\right)$ are then inversely permuted by $h_{ij}^{-1}$, delivering a message $\Gamma(M_{C_i2V_j})$, and sent to the second decompression block $\Gamma^{-1}$.

After the inverse permutation process, the message $\Gamma(M_{C_i2V_j})$ is received by the second decompression block $\Gamma^{-1}$ and expanded back to q (for example $q = 8$ in the example illustrated in Figure 3B).

The second decompression block $\Gamma^{-1}$ thus reconstructs the full-set $q$ message $\Gamma^{-1}(\Gamma(M_{C_i2V_j}))$.

This reconstruction can be based on a three steps process.

First, the LLRs of the $n_B$ best candidates are placed into their corresponding GF positions. Then, the LLR of the $n_R$ requested symbols are also set into their corresponding GF positions. Finally, the remaining positions are filled with the default LLR value $S_D$.

More specifically, the measure of reliability (LLR) associated with at least one of said $n_R$ requested symbols can be set to a default value $\boldsymbol{S_R}$ when said measure of reliability is above a threshold. Such saturation process prevents high values from entering the variable node.

In summary, for a given GF value $a \in GF(q)$:

$$\Gamma^{-1}\left(\Gamma\left(M_{C_i2V_j}\right)\right)[a]^+ = M^+_{C_i2V_j}[a] = \begin{cases} M^{B+}_{C_i2V_j}[a] & a \in M^{B+}_{C_i2V_j} \\ \min\left(M^{R+}_{C_i2V_j}[a], S_R\right) & a \in M^{R+}_{C_i2V_j} \\ S_D & otherwise \end{cases}$$

The saturation values of $S_R$ and $S_D$ can impact the decoder performance.

For example, $S_R$ and $S_D$ are determined as $S_R = S + O_R$ and $S_D = S + O_D$, with S given as a linear function of the maximum LLR values of the sets $M_{C_i2V_j}^{B+}$ and $M_{C_i2V_j}^{R+}$, i.e.

$$S = \gamma_B . max \left\{ M_{C_i2V_j}^{B+} \right\} + \gamma_R . max \left\{ M_{C_i2V_j}^{R+} \right\}$$

where the values of ($\gamma_B$, $\gamma_R$, $O_R$, $O_D$) depend on the code rate.

In the example illustrated in Figure 3B, if the saturation parameters ($\gamma_B$, $\gamma_R$, $O_R$, $O_D$) are set to (2,1/8,1,2) respectively, then the saturation values of $S_R$ and $S_D$ are $S_R$ = 6 and $S_D$ = 7, with $max \left\{ M_{C_i2V_j}^{B+} \right\} = 2$ and $max \left\{ M_{C_i2V_j}^{R+} \right\} = 8$ :

$$S = 2 \times 2 + \frac{1}{8} \times 8 = 5$$

$$S_R = 5 + 1 = 6$$

$$S_D = 5 + 2 = 7$$

In the full-set $q$ message $\Gamma^{-1}(\Gamma(M_{C_i2V_j}))$, the $n_B$ best candidates are kept unchanged, the LLR on the requested symbol $\alpha^0$, which is equal to 4, is also kept unchanged, while the LLR on the requested on symbol $\alpha^5$, which is equal to 8, is saturated from 8 down to $S_R$ = 6. The remaining candidates are all assigned the value $S_D$ = 7. Thus $\Gamma^{-1}(\Gamma(M_{C_i2V_j}))$ = [7,4,2,7,7,0,6,7] = $M_{C_i2V_j}$.

The first decoding iteration is now finished.

At least one other decoding iteration can be implemented, based on a next message $M_{V_j2C_i}$ determined by the variable node processing, such as for example disclosed in lines 13, 14 and 15 of the LDBC non binary decoding algorithm described in Annex 1.

In the example illustrated in Figure 3B, for the second decoding iteration, the next message $M_{V_j2C_i}$ is $M_{V_j2C_i}$ = [9,0,9,6,20,4,1,10].

*C. EMS-based BRD Decoder*

As disclosed above, the proposed BRD algorithm can be well integrated with the Trellis Extended Min Sum (T-EMS) based decoders since, by construction, the CN unit of the T-EMS decoder obtains the reliability of the $q$ candidates without any truncation.

According to at least one embodiment, when the proposed BRD algorithm is integrated with an EMS-based decoder, additional operations could be implemented to obtain the LLR of the requested symbols. Indeed, by construction, the size of the exchanged messages between the CN and the VN is truncated from $q$ to $n_m$ in EMS-based decoder. The message truncation leads to losing the reliability of the requested candidates if those candidates are not in the set of the most reliable ($n_m$) candidates.

The EMS algorithm can be implemented using the Elementary Check Node (ECN) architecture. The ECN architecture is a semi-parallel architecture based on 3. ($d_c$ - 2) ECNs, where $d_c$ is the degree of connectivity of the CN, arranged in three layers (the forward layer, the backward layer and the merge), each having $d_c$ - 2. Such architecture is for example disclosed in "Simplified check node processing in nonbinary LDPC decoders" (E. Boutillon and L. Conde-Canencia, in 2010 6th International Symposium on Turbo Codes Iterative Information Processing, 2010, pp. 201-205).

Figure 4 gives an example of an ECN architecture for $d_c$ = 6.

According to at least one embodiment, the output ECNs (shaded in Figure 4) implement an additional process which is finding or approximating the reliability of the requested symbols.

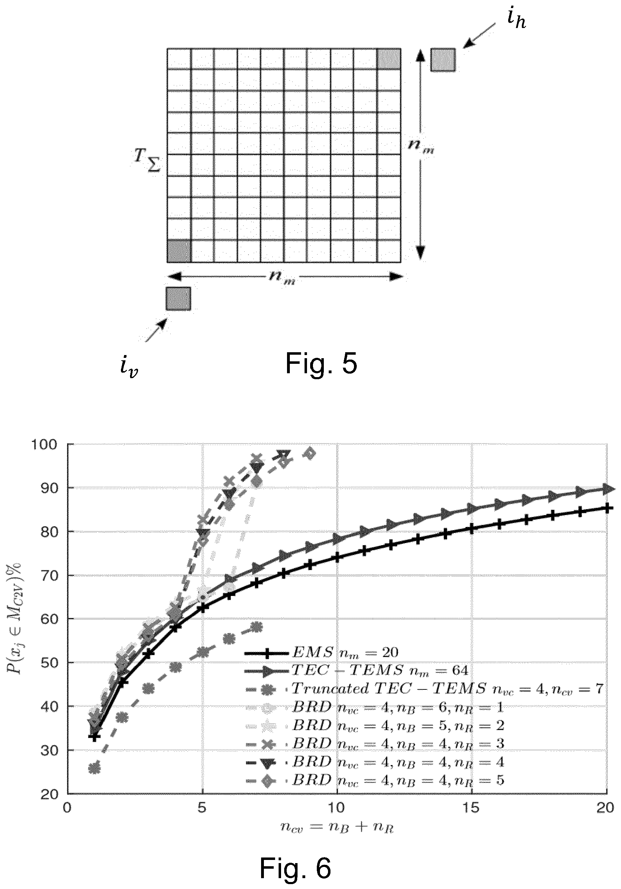

As illustrated in Figure 5, the requested symbols can be found in a $n_m \times n_m$ matrix, by using two input values. Two values can be set: the index of the vertical value $i_v$ and the index of the horizontal value $i_h$.

If we assume that the inputs of an output ECN (shaded ECN of figure 4) are two vectors of a (GF, LLR) pair

($U^{\oplus}$, $U^{+}$) and ($V^{\oplus}$, $V^{+}$), each of size $n_m$, resulting in matrices $T_{\Sigma}^{\oplus}$ and $T_{\Sigma}^{+}$ of size $n_m \times n_m$ respectively, the $n_R$ best candidates can be found by using the conventional bubble check presented in the above mentioned document "Simplified check node processing in nonbinary LDPC decoders".

In addition, the reliability of a requested symbol $\alpha$ can be found as the minimum value of three possible values:

- the first possible value is the value obtained from the minimum value $T_{\Sigma ij}^{+} = U_i^{+} + V_j^{+}$ such that

$$T_{\Sigma ij}^{\oplus} = U_i^{\oplus} \oplus V_j^{\oplus} = \alpha,$$

- the second value is the horizontal approximation value $i_h$: $i = T_{\Sigma 0,n_m} + O_H$,

- the third value is the vertical approximation value $i_v$: $i_v = T_{\Sigma n_m,0} + O_V$,

where $O_H$ and $O_V$ are offset values, that can for example be obtained from simulation.

Once the reliability values of the requested symbols are found or approximated, the saturation process of the BRD decoder can determine the saturation value $S_D$ that can be used as a default value for the remaining symbols, as well as the saturation value $S_R$ that can be used for some of the requested symbols as previously described.

$$S = Sat = \gamma_B . max\{M_{C2V}^{B+}\} + \gamma_R . max\{M_{C2V}^{R+}\} = 2\, max\{M_{C2V}^{B+}\} + \frac{max\{M_{C2V}^{R+}\}}{8}$$

The remaining candidates in $M_{C2V}^{D}$ have a fixed reliability which is $S_D = Sat$.

The requested candidates are saturated at $S_R = \gamma \times Sat$ if their LLR exceeds the threshold $\gamma \times Sat$:

$$M_{C2V}^{R+}[a] = \begin{cases} M_{C2V}^{R+}[a] & if\ M_{C2V}^{R+}[j] \leq \gamma \times Sat \\ \gamma \times Sat & otherwise \end{cases} \quad \forall a \in M_{C2V}^{R\oplus}$$

*D. Simulation results*

In the prior art EMS algorithm, it is known that the size $n_m$ of the $M_{C2V}$ messages affects the performance of the decoder. However, the main criterion that affects the performance is not the size of the message in itself, but the probability $P(x_j \in M_{Ci2Vj})$ that the transmitted symbol $x_j$ belongs effectively to the exchanged message.

As demonstrated below, the proposed BRD algorithm with requested candidates increase this probability significantly, thus leading to good decoding performance even with low message size.

*D.1. Statistical Analysis*

In this section, a Monte-Carlo estimation of $P(x_j \in M_{Ci2Vj})$ is presented as a function of the message size for several decoding algorithms. The Monte-Carlo simulations are performed for a rate 5/6 ($d_v = 2$, $d_c = 12$) GF(64) NB-LDPC code of size $N = 864$ symbols. As $d_v = 2$, the index $i$ of the check node can be omitted.

The Signal-to-Noise Ratio (SNR) is set to 3 dB (beginning of the waterfall region) with a maximum of 30 decoding iterations. The probability $P(x_j \in M_{C2Vj})$ is estimated in the whole decoding process as a function of the $M_{C2V}$ message length.

For the EMS algorithm, the message length is given by $n_m$. The algorithm parameters are $n_{op} = n_m + 5$ and offset value equals to 0.3, such as for example detailed in the document "Decoding Algorithms for Non-Binary LDPC Codes Over GF(q)" cited in the background section.

For the BRD proposed algorithm, the message length is characterized by $n_{cv} = n_B + n_R$. For this simulation, the CN process is for example based on the TEC-TEMS algorithm, with specific parameters given below.

Figure 6 illustrates the probability $P(x_j \in M_{C2Vj})$ for $N = 864$, $K = 720$ on $GF(64)$, for different decoding algorithms:

- the EMS algorithm with $n_m = 20$,
- the TEC-TEMS algorithm with $n_m = 64$,
- the Truncated TEC-TEMS with $n_{vc} = 4$ and $n_{cv} = 7$,

- the BRD algorithm with $n_{vc}$ = 4 , $n_B$ = 6 and $n_R$ = 1,
- the BRD algorithm with $n_{vc}$ = 4, $n_B$ = 5 and $n_R$ = 2,
- the BRD algorithm with $n_{vc}$ = 4, $n_B$ = 4 and $n_R$ = 3,
- the BRD algorithm with $n_{vc}$ = 4, $n_B$ = 4 and $n_R$ = 4,
- the BRD algorithm with $n_{vc}$ = 4, $n_B$ = 4 and $n_R$ = 5.

It can be seen on Figure 6 that including the requested symbols greatly enhances the probability that the transmitted symbol $x_j$ belongs to the propagated message $M_{C2V}$, and hence becomes a possible candidate to be processed at both VN and CN.

The probability $P(x_j \in M_{C2V_j})$ is around 85% in EMS with $n_m$ = 20. The probability $P(x_j \in M_{C2V_j})$ in TEC-TEMS has a similar percentage (87%) to EMS. When truncating the size of considered candidates to $n_{vc}$ = 4 and $n_{cv}$ = 7 (i.e $n_B$ = 7 and $n_R$ = 0), the probability drops down to 59%. Including one requested symbol $n_B$ = 6 and $n_R$ = 1 enhances the overall probability from 59% to 89% with the same message size ($n_{cv}$ = 7). The proposed decoder with $n_B$ = 4 and $n_R$ = 3, achieves a probability of 96%.

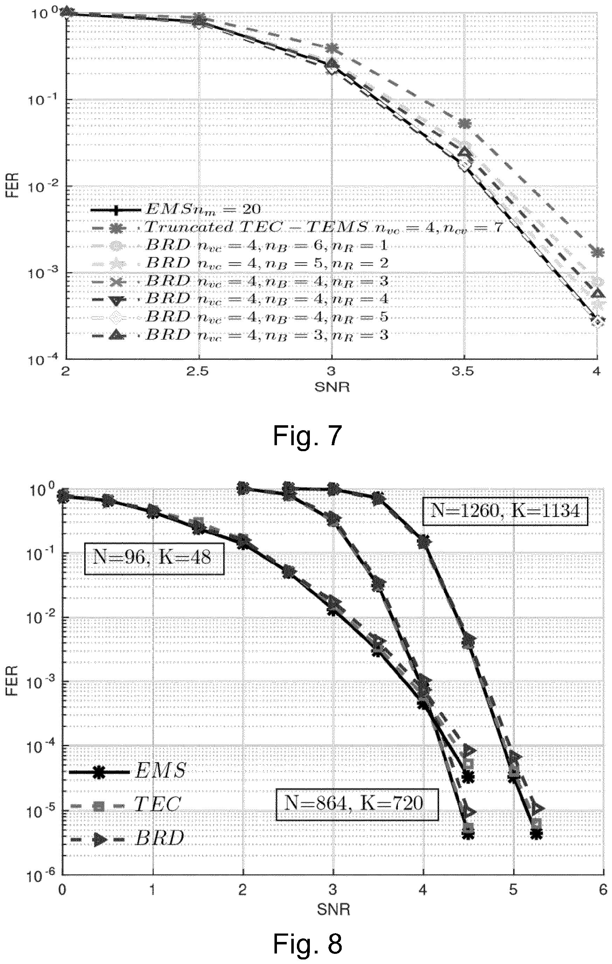

Figure 7 shows the impact of the decoder parameters on the Frame Error Rate (FER), for the aforementioned analyzed schemes.

It can be seen on Figure 7 that the worst performance is for the truncated TEC-TEMS with $n_{vc}$ = 4 and $n_{cv}$ = 7. Moreover, it can be noted that increasing the number of requested symbols further does not enhance the decoding performance of the decoder.

*D.2 Results*

The number of the exchanged messages reflects the number of memory resources required for the decoding process to be performed. Reducing the number of messages exchanged reduces the latency/complexity of different processes of the decoder such as the sorting processes, the permutation and inverse permutation processes, the configuration sets builder, and the memory resources allocation which benefits both hardware-implemented and software-implemented decoders. The overhead complexity of the compression and decompression block depends on the CN processing algorithm used.

Table I below shows the size of exchanged messages per edge (a connection between a VN and a CN) for different schemes based on GF(64). The message size is characterized by the number of GF values (coded on $log_2$(64) = 6 bits) and the number of LLR values (also coded on 6 bits). The last column sums the number of GF and LLR elements exchanged per edge and per iteration.

Table I

| Scheme | Algorithm | Inputs | | Outputs | | Total |
|---|---|---|---|---|---|---|
| | | $n_{vc}^{\oplus}$ | $n_{vc}^{+}$ | $n_{cv}^{\oplus}$ | $n_{cv}^{+}$ | |
| EMS | FWBW | 20 | 19 | 20 | 19 | 78 |
| | Hybrid EMS | 5 | 4 | 20 | 19 | 48 |
| TEMS | TEMS | 0 | 64 | 0 | 64 | 128 |
| | TEC-TEMS | 0 | 64 | 0 | 64 | 128 |
| | Improved TEMS | 32 | 31 | 0 | 64 | 127 |
| BRD | for r $\geq$ 5/6 | 4 | 3 | 4 | 6 | 17 |
| | for r = 1/2 | 5 | 4 | 6 | 8 | 23 |

For a code on GF(64) with $r$ = 5/6 and a CN degree of connectivity $d_c$ = 12, the lowest number of the exchanged elements among the studied scheme is 48, achieved by the hybrid EMS decoder (disclosed for example by C. Marchand, E. Boutillon, H. Harb, L. Conde-Canencia, and A. Al Ghouwayel, in "Hybrid Check Node Architectures for NB-LDPC Decoders" (IEEE Transactions on Circuits and Systems I: Regular Papers, vol. 66, no. 2, pp. 869-880, 2019)), whereas the total number of exchanged elements per edge in the proposed BRD decoder is 17. Furthermore, the number of the memory resources reserved is greatly reduced from $d_c \times$ q down to $d_c \times$ 7 for $M_{V2C}$ messages, and from $d_c \times$ q down to $d_c \times$ 10 for $M_{C2V}$ messages.

For a code rate $r$ = 0.5 with a degree of connectivity $d_c$ = 4, the number of exchanged messages is set to $n_{vc}$

= 5, $n_B$ = 6 and $n_R$ = 3. The factors $\gamma_R$ and $\gamma_B$ are for example 0.127 and 2.24 respectively, and can be optimized to 0.125 and 2 such that the multiplication is simplified to a shifting operation.

The simulation is done for NB-LDPC codes of size (in bits) (96,48), (864,720) and (1260,1134) on GF(64). The simulated decoder is based on the layered scheduling and a maximum of 10 decoding iterations.

Simulation results for different sizes of code are illustrated in Figure 8.

As shown in Figure 8, the proposed BRD scheme has a performance similar to that of the EMS (with $n_m$ = 20 and $n_{op}$ = 25) and TEC-TEMS. The performance is simulated down to a FER of $10^{-5}$ and no significant performance degradation is experienced.

The parameters used for simulating the BRD decoder for $r \geq$ 5/6 are $n_{vc}$ = 4, $n_B$ = 4, $n_R$ = 3, $\gamma_R$ = 0,125, $\gamma_B$ = 2, $O_D$ = 0.4, $O_R$ = 0.2 and a compensation factor (TEC-TEMS) = 0.8.

For a code of size $N$ = 96, $K$ = 48 with $d_c$ = 4, the BRD decoder showed similar performance to EMS with a lower number of exchanged messages ($n_{vc}$ = 5, $n_B$ = 6, and $n_R$ = 3, instead of $n_m$ = 20 and $n_{op}$ = 25). The parameters used for this simulation are $\gamma_R$ = 0,125, $\gamma_B$ = 2, $O_D$ = 0.2, $O_R$ = 0.1 and a compensation factor (TEC-TEMS) = 0.8.

As compared to a binary LDPC code, it can be noticed that a binary LDPC code sends two messages per edge per iteration. For a $d_v$ = 3 LDPC code, each binary VN exchanges 6 messages per iteration. Thus, 6 binary VNs (equivalent to 1 VN in GF(64)) sends 36 messages per iteration. Considering a rate $r \geq$ 5/6 and $d_v$ = 2 in GF(64)-LDPC code, only $17 \times d_v$ = 34 messages are exchanged. Therefore, the BRD decoder requires less communication load than a binary decoder.

## 5.3 Other codes

As already mentioned, the scope of the invention is not limited to the NB-LDPC codes, nor to the use of parity check. In fact, any code represented by a graph with several "non-binary constraint nodes" (or "sub-codes") and "variable nodes" (each sub-codes constraint a sub-set of variables) can implement the disclosure.

We present below two examples with different codes, one considering a turbo-code, the other one considering a polar code.

Document "Design of Low-Complexity Convolutional Codes over GF(q)" from R. Klaimi, C. Abdel Nour, C. Douillard and J. Farah (2018 IEEE Global Communications Conference (GLOBECOM), Abu Dhabi, United Arab Emirates, 2018, pp. 1-7) gives an example of non-binary convolutional encoder used in a non binary Turbo-code.

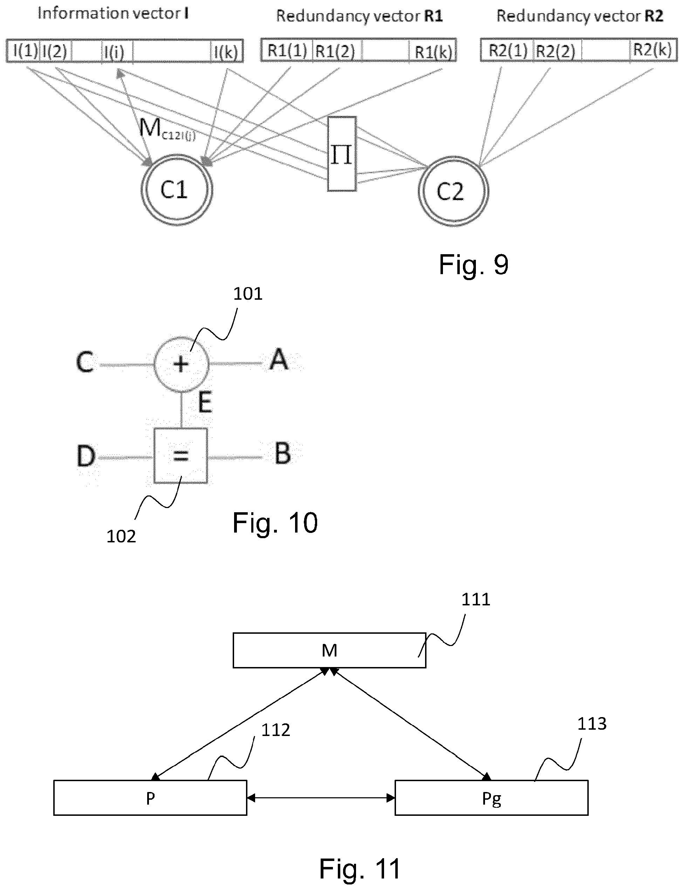

A non-binary turbo-code can be viewed as a bipartite graph, such as illustrated in Figure 9. For example, the set of k information symbols I = {$I(1)$, $I(2)$, ..., $I(k)$} and of k redundancy symbols **R1** = {$R1(1)$, $R1(2)$, ... $R1(k)$} participate to a first non-binary convolutional code C1, while the set of a permuted version of the information symbols $P(\mathbf{I})$ and of k redundancy **R2** = {$R2(1)$, $R2(2)$, ... $R2(k)$} participate to a second non-binary convolutional code C2.

The turbo-decoding algorithm is also an instance of the Belief Propagation algorithm in this Tanner graph. This mean that symbol reliabilities are exchanged among the branches of the graph, between the convolutional decoder C1 or C2 ("non-binary constraint nodes") and the information or redundancy symbols ("variable nodes").

Using known principle of the extrinsic information, the message $M_{C12I(j)}$ send for example from the convolutional decoder C1 to the jth information symbol $I(j)$ is a function of the symbol reliabilities of $\mathbf{I} \setminus I(j)$ (i.e. vector **I** with the symbol $I(j)$ excluded) and **R1.**

In this context, reducing the size of the message $M_{C12I(j)}$ as proposed in the disclosure, as a union of the set of the $n_B$ best symbol reliabilities, the $n_R$ requested symbol reliabilities (the $n_R$ best symbols of the $M_{I(j)2C1}$ message for example) and a default value, is a natural extension of what has been presented in the NB-LDPC context.

We now consider a polar code; the so-called kernel of a polar code is presented in Figure 10. The "+" box 101 represents a parity check of degree 3 over GF(q), while the "=" box represents an identity constraint of degree 3, which is similar in processing to a variable node.

Many polar code decoding algorithms (such as "Successive Cancellation", or iterative decoder) process the parity check node of degree 3 to generate an output message that is used in a following kernel or in a decision unit. For example, from messages D, B it is possible to generate a message E, then from messages E and A, it is possible to generate an output message C by a classical non-binary check node processing. The size of the message C sent by the check node 101 to a "variable node" of a following kernel or a decision unit can be reduced by applying the same Best/Requested/Default mechanisms than described for the NB-LDPC code or Turbo-Code.

More generally, the method can be applied to any non-binary code that can be decoded as an instance of a message passing algorithm.

## 5.4 Structure

Finally, in relation to Figure 11, the simplified structure of a non-binary decoder according to at least one embodiment described above is presented.

Such a decoder comprises at least one memory 111 comprising a buffer memory, at least one processing unit 112, equipped for example with a programmable computing machine or with a dedicated computing machine, for example a processor P, and controlled by the computer program 113, implementing steps of the method for decoding a codeword according to at least one embodiment of the invention.

Upon initialisation, the code instructions of the computer program 113 are for example loaded into a RAM memory before being executed by the processor of the processing unit 112.

The processor of the processing unit 112 implements steps of the method for decoding a codeword described above, according to the instructions of the computer program 113, to send a message from the non-binary constraint node to the non-binary variable node $V_j$, said message comprising:

- $n_R$ measures of reliability obtained for $n_R$ candidate symbols selected by the variable node $V_j$ or by a first compression block implemented between the non-binary variable node $V_j$ and the non-binary constraint node $C$,
- $n_B$ measures of reliability obtained for $n_B$ candidate symbols selected by the non-binary constraint node $C$ or by a second compression block implemented between the non-binary constraint node $C$ and the variable node $V_j$,

with $1 \leq n_B < q$, $1 \leq n_R < q$ and $n_R + n_B < q$.

**ANNEX 1**

---

**Algorithm 1:** Layered $d_v = 2$ NB-LDPC Decoding Algorithm

---

**Input: H**, $iter_{max}, \{I_j\}_{j=1,2,...,N}$

**1 Initialization:** $iter = 0$

**2 for** $j = 1$ **to** $N$ **do**

**3** $\quad$ $\hat{x}_j = \min(I_j);\ M_{V_j 2C} = I_j;\ M_{C2V_j}^{old} = 0;$

**4 end**

**5 while** $iter < iter_{max}$ **&** $\boldsymbol{H}\hat{\boldsymbol{x}} \neq 0$ **do**

**6** $\quad$ **for** $i = 1$ **to** $N - K$ **do**

**7** $\qquad$ Check Node Processing:

**8** $\qquad$ $\forall j \in \mathcal{N}(i),\ M_{V_j 2C}^P = h_{i,j} \times M_{V_j 2C}$

**9** $\qquad$ $\{M_{C2V_j}^P\}_{j\in\mathcal{N}(i)} = \Phi(\{M_{V_{j'} 2C}^P\}_{j'\in\mathcal{N}(i)\backslash j})$

**10** $\qquad$ $\forall j \in \mathcal{N}(i)\ M_{C2V_j} = h_{i,j}^{-1} \times M_{C2V_j}^P$

**11** $\qquad$ Variable Nodes Processing:

**12** $\qquad$ **forall** $j \in \mathcal{N}(i)$ **do**

**13** $\qquad\quad$ $APP_j = M_{C2V_j}^{old} + M_{C2V_j} + I_j$

**14** $\qquad\quad$ $M_{V_j 2C} = APP_j - M_{C2V_j}^{old}$

**15** $\qquad\quad$ $M_{V_j 2C} = M_{V_j 2C} - \min(M_{V_j 2C})$

**16** $\qquad\quad$ $M_{C2V_j}^{old} = M_{C2V_j}$

**17** $\qquad$ **end**

**18** $\qquad$ Decision Stage:

**19** $\qquad$ **for** $j = 1$ **to** $N$ **do**

**20** $\qquad\quad$ $\hat{x}_j = \arg\min_{a\in GF(q)}\{APP_j[a]\}$

**21** $\qquad$ **end**

**22** $\qquad$ $iter{+}{+}$

**23** $\quad$ **end**

**24 end**

**Output:** $\hat{\mathbf{x}}$

---

**Claims**

1. A method for decoding a codeword,

   said codeword being obtained by implementing a code comprising at least one non-binary constraint node $C$ over a set $S$ of cardinality $q > 2$ defined from a parity check matrix $\mathbf{H_C}$ of the non-binary constraint node $C$ by the equation $\mathbf{H_C} \cdot (p_1(V_1), p_2(V_2), ... , p_{d_c}(V_{d_c}))^T = 0$, where $V_1, V_2, ... , V_{d_c}$ are a sub-set of non-binary variable nodes of the codeword implied in the non-binary constraint node $C$, with $d_c > 2$ the degree of connectivity of the non-binary constraint node $C$ and $p_1, p_2, ...p_{d_c}$ are permutations over the set $S$,
   wherein said decoding method implements, for at least one connection between the non-binary variable node $V_j$, $1 \le j \le d_c$, and the non-binary constraint node $C$, at least one decoding iteration comprising sending (21) a message from the non-binary constraint node $C$ to the non-binary variable node $V_j$, said message comprising:

   - $n_R$ measures of reliability obtained for $n_R$ candidate symbols selected by the non-binary variable node $V_j$ or by a first compression block implemented between the non-binary variable node $V_j$ and the non-binary constraint node $C$, said $n_R$ candidate symbols being denoted $n_R$ requested symbols,

- $n_B$ measures of reliability obtained for $n_B$ candidate symbols selected by the non-binary constraint node $C$ or by a second compression block implemented between the non-binary constraint node $C$ and the non-binary variable node $V_j$, said $n_B$ candidate symbols being denoted $n_B$ best symbols, with $1 \leq n_B < q$, $1 \leq n_R < q$ and $n_R + n_B < q$.

**2.** The method according to claim 1, wherein said $n_R$ requested symbols are selected as the $n_R$ most reliable symbols from at least one of:

- an intrinsic message obtained from the channel observation,
- an *a posteriori* probability message,
- a message from the non-binary variable node $V_j$ to the non-binary constraint node $C$.

**3.** The method according to any one of claims 1 or 2, wherein said $n_B$ best symbols are selected as the $n_B$ most reliable symbols from an extrinsic message issued by the non-binary constraint node $C$.

**4.** The method according to any one of claims 1 to 3, wherein said message sent from the non-binary constraint node $C$ to the non-binary variable node $V_j$ also comprises the $n_B$ best symbols.

**5.** The method according to any one of claims 1 to 4, wherein said at least one decoding iteration further comprises transmitting a message from the non-binary variable node $V_j$ to the non-binary constraint node $C$, comprising:

- generating a message $M_{V_j2C}$ comprising measures of reliability obtained for the q candidate symbols of the set $S$,
- selecting from the message $M_{V_j2C}$, by the first compression block $\Omega$, $n_{vc}$ candidate symbols and generating a message $\Omega(M_{V_j2C})$ comprising the $n_{vc}$ symbols and the measures of reliability obtained for said $n_{vc}$ symbols,
- selecting, by the first compression block $\Omega$, the $n_R$ requested symbols from the message $M_{V_j2C}$, and sending a message $M^{R,\oplus}$ to a second decompression block $\Gamma^{-1}$, comprising the $n_R$ requested symbols,
- permuting the $n_{vc}$ symbols of the message $\Omega(M_{V_j2C})$, delivering a message $\Omega\left(M_{V_j2C}^P\right)$, and the $n_R$ requested symbols, delivering a message $M^{P,R,\oplus}$,
- reconstructing, by a first decompression block $\Omega^{-1}$, a message $\Omega^{-1}\left(\Omega\left(M_{V_j2C}^P\right)\right)$ comprising the $n_{vc}$ symbols, the measures of reliability obtained for said $n_{vc}$ symbols, remaining $q - n_{vc}$ symbols, and measures of reliability set to a default value for the remaining $q - n_{vc}$ symbols,
- transmitting to the second compression block $\Gamma$ the message $M^{P,R,\oplus}$, comprising the $n_R$ requested symbols after permutation.

**6.** The method according to claim 5, wherein said message sent from the non-binary constraint node $C$ to the non-binary variable node $V_j$ is sent when the non-binary constraint node $C$ has received messages $M_{V2C}^P$ from all the non-binary variable nodes connected to the non-binary constraint node $C$, and is obtained from:

- generating, from the $M_{V_k2C}^P$ received messages, $k \neq j$, a message $M_{C2V_j}^P$, comprising measures of reliability obtained for the q candidate symbols of the set $S$,
- selecting from the message $M_{C2V_j}^P$, by the second compression block $\Gamma$, $n_B$ best symbols and generating a message $M_{C2V_j}^{P,B}$ comprising the $n_B$ best symbols and the measures of reliability obtained for said $n_B$ best symbols,
- obtaining, from the message $M_{C2V_j}^P$, the measures of reliability of the $n_R$ requested symbols after permutation received by the second compression block $\Gamma$ in the message $M^{P,R,\oplus}$,
- generating a message $\Gamma\left(M_{CV_j}^P\right)$ comprising the message $M_{C2V_j}^{P,B}$ and the measures of reliability of the $n_R$ requested symbols after permutation,

- inversely permuting the $n_B$ best symbols of the message $\Gamma\left(M_{C2V_j}^P\right)$, delivering a message $\Gamma\left(M_{C2V_j}\right)$,

- reconstructing, by the second decompression block $\Gamma^{-1}$, a message $\Gamma^{-1}(\Gamma(M_{C2V_j}))$ comprising the $n_B$ best symbols, the measures of reliability obtained for said $n_B$ best symbols, the $n_R$ requested symbols, the measures of reliability obtained for said $n_R$ requested symbols, $n_D$ remaining symbols and measures of reliability obtained for said $n_D$ remaining symbols set to a default value $S_D$.

7. The method according to any one of claims 1 to 6, wherein the measure of reliability obtained for at least one of said $n_R$ requested symbols is set to a default value $S_R$ when said measure of reliability is above a threshold.

8. The method according to any one of claims 1 to 7, wherein said non-binary constraint node implements a decoding function belonging to the group comprising:

- a Min-Max function,
- an Extended MinSum function,
- a Trellis-Extended MinSum function,
- a threshold-based truncation decoding function,
- a Belief Propagation function,
- a Fourier domain implementation of a Belief Propagation function,
- a Forward/Backward function.

9. The method according to any one of claims 1 to 8, wherein the non-binary constraint node is a parity check node with a degree of connectivity $d_v$ given as $p_1 (V_1) + p_2(V_2) + \cdots + p_{d_c}(V_{d_c}) = 0$ over the set $S$.

10. The method according to any one of claims 1 to 8, wherein the non-binary constraint node is a convolutional code.

11. The method according to any one of claims 1 to 10, wherein the code belongs to the group comprising:

- a LDPC code,
- a polar code,
- a turbo-code.

12. The method according to any one of claims 1 to 11, wherein the message sent from the non-binary constraint node $C$ to the non-binary variable node $V_j$ comprises a default symbol reliability associated with $n_D$ remaining symbols that do not belong to the set of $n_B$ best symbols nor to the set of $n_R$ requested symbols.

13. The method according to any one of claims 1 to 12, wherein the message sent from the non-binary constraint node $C$ to the non-binary variable node $V_j$ comprises at most $n_B + n_R + 1$ measures of reliabilities.

14. A device for decoding a codeword,

said codeword being obtained by implementing a code comprising at least one non-binary constraint node $C$ over a set $S$ of cardinality $q > 2$ defined from a parity check matrix $\mathbf{H_C}$ of the non-binary constraint node $\boldsymbol{C}$ by the equation $\mathbf{H_C}.(p_1(V_1), p_2(V_2), \dots , p_{d_c}(V_{d_c}))^T = 0$, where $V_1, V_2, \dots , V_{d_c}$ are a sub-set of non-binary variable nodes of the codeword implied in the non-binary constraint node $C$, with $d_c > 2$ the degree of connectivity of the non-binary constraint node $C$ and $p_1, p_2, ...p_{d_c}$ are permutations over the set $S$,
wherein said decoding device comprises at least one processor configured to implement, for at least one connection between the non-binary variable node $V_j$, $1 \leq j \leq d_c$, and the non-binary constraint node $C$, at least one decoding iteration comprising sending a message from the non-binary constraint node $C$ to the non-binary variable node $V_j$,
said message comprising:

- $n_R$ measures of reliability obtained for $n_R$ candidate symbols selected by the non-binary variable node $V_j$ or by a first compression block implemented between the non-binary variable node $V_j$ and the non-binary constraint node $C$, said $n_R$ candidate symbols being denoted $n_R$ requested symbols,
- $n_B$ measures of reliability obtained for $n_B$ candidate symbols selected by the non-binary constraint node *C* or by a second compression block implemented between the non-binary constraint node *C* and the non-binary variable node $V_j$, said $n_B$ candidate symbols being denoted $n_B$ best symbols,

with $1 \leq n_B < q$, $1 \leq n_R < q$ and $n_R + n_B < q$.

**15.** A computer program including instructions for implementing a method according to claim 1 when this program is executed by a processor.


**Patentansprüche**

**1.** Verfahren zur Dekodierung eines Codewortes,

wobei das Codewort durch Implementierung eines Codes erhalten wird, der mindestens einen nicht binären Zwangsknoten C über eine Menge S mit einer Kardinalität $q > 2$ umfasst, die ausgehend von einer Paritätsprüfungsmatrix $\mathbf{H}_C$ des nicht binären Zwangsknotens C durch die Gleichung $\mathbf{H}_C \cdot (p_1(V_1), p_2(V_2), \dots, p_{d_c}(V_{d_c}))^T = 0$ definiert wird, wobei $V_1, V_2, \dots, V_{d_c}$ eine Untermenge nicht binärer variabler Knoten des Codewortes sind, das in dem nicht binären Zwangsknoten C impliziert ist, mit $d_c > 2$ der Grad der Konnektivität des nicht binären Zwangsknotens C und $p_1, p_2, \dots p_{d_c}$ Permutationen über die Menge S sind,
wobei das Dekodierverfahren für mindestens eine Verbindung zwischen den nicht binären variablen Knoten $V_j$, $1 \leq j \leq d_c$, und dem nicht binären Zwangsknoten C zumindest eine Dekodieriteration implementiert, die das Senden (21) einer Nachricht von dem nicht binären Zwangsknoten C an den nicht binären variablen Knoten $V_j$ umfasst, wobei die Nachricht aufweist:

- $n_R$ Zuverlässigkeitsmaßnahmen, die für $n_R$ Kandidatensymbole erhalten werden, die durch den nicht binären variablen Knoten $V_j$ oder durch einen ersten Kompressionsblock ausgewählt werden, der zwischen dem nicht binären variablen Knoten $V_j$ und dem nicht binären Zwangsknoten C implementiert wird, wobei die $n_R$ Kandidatensymbole als $n_R$ angeforderte Symbole bezeichnet werden,
- $n_B$ Zuverlässigkeitsmaßnahmen, die für $n_B$ Kandidatensymbole erhalten werden, die von dem nicht binären Zwangsknoten C oder von einem zweiten Kompressionsblock ausgewählt werden, der zwischen dem nicht binären Zwangsknoten C und dem nicht binären variablen Knoten $V_j$ implementiert wird, wobei die $n_B$ Kandidatensymbole als $n_B$ beste Symbole bezeichnet werden,

mit $1 \leq n_B < q$, $1 \leq n_R < q$ und $n_R + n_B < q$.

**2.** Das Verfahren nach Anspruch 1, wobei die $n_R$ angeforderten Symbole als die $n_R$ am zuverlässigsten Symbole aus mindestens einem der folgenden ausgewählt werden:

- einer intrinsischen Nachricht, die aus der Kanalbeobachtung erhalten wird,
- eine a posteriori Wahrscheinlichkeitsnachricht,
- eine Nachricht von dem nicht binären variablen Knoten $V_j$ an den nicht binären Zwangsknoten C.

**3.** Das Verfahren nach einem der Ansprüche 1 oder 2, wobei die $n_B$ besten Symbole als die $n_B$ am zuverlässigsten Symbole aus einer extrinsischen Nachricht ausgewählt werden, die von dem nicht binären Zwangsknoten C ausgegeben wird.

**4.** Das Verfahren nach einem der Ansprüche 1 bis 3, wobei die Nachricht, die von dem nicht binären Zwangsknoten C zu dem nicht binären variablen Knoten $V_j$ gesendet wird auch die $n_B$ besten Symbole aufweist.

**5.** Das Verfahren nach einem der Ansprüche 1 bis 4, wobei die zumindest eine Dekodierinteration ferner das Übertragen einer Nachricht von dem nicht binären variablen Knoten $V_j$ zu dem nicht binären Zwangsknoten C umfasst, aufweisend:

- Generieren einer Nachricht $M_{Vj2C}$ aufweisend Zuverlässigkeitsmaßnahmen, die für die q Kandidatensymbole der Menge S erhalten werden,
- Auswählen von $n_{vc}$ Kandidatensymbolen aus der Nachricht $M_{Vj2C}$ durch den ersten Kompressionsblock $\Omega$ und Generieren einer Nachricht $\Omega(M_{Vj2C})$ aufweisend die $n_{vc}$ Symbole und die Zuverlässigkeitsmaßnahmen, die für diese $n_{vc}$ Symbole erhalten wurden,

- Auswählen der $n_R$ angeforderten Symbole aus der Nachricht $M_{Vj2c}$ durch den ersten Kompressionsblock $\Omega$ und Senden einer Nachricht $M^{R,\oplus}$ zu einem zweiten Dekompressionsblock $\Gamma^{-1}$, aufweisend die $n_R$ angeforderten Symbole,

- Permutieren der $n_{vc}$ Symbole der Nachricht $\Omega(M_{Vj2C})$, Liefern einer Nachricht $\Omega\left(M_{Vj2C}^P\right)$ , und die $n_R$ angeforderten Symbole, Liefern einer Nachricht $M^{P,R,\oplus}$,

- Rekonstruieren einer Nachricht $\Omega^{-1}\left(\Omega\left(M_{Vj2C}^P\right)\right)$ mit den $n_{vc}$ Symbolen, den Zuverlässigkeitsmaßnahmen, die für die $n_{vc}$ Symbole erhalten werden, verbleibende $q - n_{vc}$ Symbole und Zuverlässigkeitsmaßnahmen, die für die verbleibenden $q - n_{vc}$ Symbole auf einem Standardwert gesetzt werden, durch einen ersten Dekompressionsblock $\Omega^{-1}$,
- Übertragen der Nachricht $M^{P,R,\oplus}$, aufweisend die $n_R$ angeforderten Symbole nach der Permutation, an den zweiten Kompressionsblock $\Gamma$.

6. Das Verfahren nach Anspruch 5, wobei die Nachricht, die von den nicht binären Zwangsknoten C zu den nicht binären variablen Knoten $V_j$ gesendet wird, wenn der nicht binäre Zwangsknoten C Nachrichten $M_{V2C}^P$ von all den nicht binären variable Knoten erhalten hat, welche mit dem nicht binären Zwangsknoten C verbunden sind, und es sich ergibt aus:

- Gerieren einer Nachricht $M_{Vk2C}^P$ , aufweisend Zuverlässigkeitsmaßnahmen, die für die q Kandidatensymbole der Menge S erhalten werden, aus der $M_{C2Vj}^P$ erhaltenen Nachricht, wobei $k \neq j$,

- Auswählen von $n_B$ besten Symbolen aus der Nachricht $M_{C2Vj}^P$ durch den zweiten Kompressionsblock $\Gamma$ und Generieren einer Nachricht $M_{C2Vj}^{P,B}$ aufweisend die $n_B$ besten Symbole und die Zuverlässigkeitsmaßnahmen, die für die $n_B$ besten Symbole erhalten werden,

- Erhalten der Zuverlässigkeitsmaßnahmen von den $n_R$ angeforderten Symbolen nach der Permutation aus der Nachricht $M_{C2Vj}^P$ , die von dem zweiten Kompressionsblock $\Gamma$ in der Nachricht $M^{P,R,\oplus}$ empfangen werden,

- Generieren einer Nachricht $\Gamma\left(M_{CVj}^P\right)$ aufweisend die Nachricht $M_{C2Vj}^{P,B}$ und der Zuverlässigkeitsmaßnahmen von den $n_R$ angeforderten Symbole nach der Permutation,

- inverses Permutieren der $n_B$ besten Symbole der Nachricht $\Gamma\left(M_{C2Vj}^P\right)$ , Liefern einer Nachricht $\Gamma\left(M_{C2Vj}\right)$ ,
- Rekonstruieren einer Nachricht $\Gamma^{-1}(\Gamma(M_{C2Vj}))$ aufweisend die $n_B$ besten Symbole, der Zuverlässigkeitsmaßnahmen, die für die $n_B$ besten Symbole erhalten werden, die $n_R$ angeforderten Symbole, die Zuverlässigkeitsmaßnahmen, die für die $n_R$ angeforderten Symbole erhalten werden, von $n_D$ verbleibenden Symbolen und von Zuverlässigkeitsmaßnahmen für die $n_D$ verbleibenden Symbole, die auf einen Standardwert $S_D$ gesetzt werden, durch den zweiten Dekompressionsblock $\Gamma^{-1}$.

7. Verfahren nach einem der Ansprüche 1 bis 6, wobei die Zuverlässigkeitsmaßnahme, die für zumindest eine der $n_R$ angeforderten Symbole erhalten wird, auf einen Standardwert $S_R$ gesetzt wird, wenn die Zuverlässigkeitsmaßnahme über einem Schwellenwert liegt.

8. Das Verfahren gemäß einem der Ansprüche 1 bis 7, wobei der nicht binäre Zwangsknoten eine Dekodierfunktion implementiert, die zu der Gruppe gehört, die umfasst:

- eine Min-Max-Funktion,
- eine erweiterte MinSum-Funktion.
- eine Trellis-Erweiterungs Min-Sum-Funktion,
- eine Schwellenwert-basierte Trunkierungs- Dekodierfunktion,
- eine Belief-Propagation-Funktion,
- eine Fourier-Domain-Implementierung einer Belief-Propagation-Funktion,
- eine Vorwärts/Rückwärts-Funktion.

9. Das Verfahren gemäß einem der Ansprüche 1 bis 8, wobei der nicht binäre Zwangsknoten ein Paritätsprüfungsknoten mit einem Grad der Konnektivität $d_v$ ist, gegeben als $p_1(V_1) + p_2(V_2) + \cdots + p_{d_c}(V_{d_c}) = 0$ über die Menge S.

10. Das Verfahren gemäß einem der Ansprüche 1 bis 8, wobei der nicht binäre Zwangsknoten ein Faltungscode ist.

11. Das Verfahren gemäß einem der Ansprüche 1 bis 10, wobei der Code zu der Gruppe gehört, aufweisend:

    - einen LDPC-Code,
    - einen Polar-Code,
    - einen Turbo-Code.

12. Das Verfahren gemäß einem der Ansprüche 1 bis 11, wobei die Nachricht, die von dem nicht binären Zwangsknoten C zu dem nicht binären variablen Knoten $V_j$ gesendet wird eine Standardsymbolzuverlässigkeit aufweist, die mit $n_D$ verbleibenden Symbolen assoziiert ist, die weder zu der Menge $n_B$ besten Symbole noch zu der Menge von $n_R$ angeforderten Symbolen gehören.

13. Das Verfahren gemäß einem der Ansprüche 1 bis 12, wobei die Nachricht, die von dem nicht binären Zwangsknoten C zu dem nicht binären variablen Knoten $V_j$ gesendet wird, höchstens $n_B + n_R + 1$ Zuverlässigkeitsmaßnahmen aufweist.

14. Eine Vorrichtung zum Dekodieren eines Codewortes,

    wobei das Codewort durch Implementierung eines Codes erhalten wird, der mindestens einen nicht binären Zwangsknoten C über eine Menge S mit einer Kardinalität q > 2 umfasst, die ausgehend von einer Paritätsprüfungsmatrix $\mathbf{H_C}$ des nicht binären Zwangsknotens C durch die Gleichung $\mathbf{H_C} \cdot (p_1(V_1), p_2(V_2), ... , p_{d_c}(V_{d_c}))^T = 0$, definiert wird,
    wobei $V_1, V_2, ..., V_{d_c}$ eine Untermenge nicht binärer variabler Knoten des Codewortes sind, das in dem nicht binären Zwangsknoten C impliziert ist, mit $d_c > 2$ der Grad der Konnektivität des nicht binären Zwangsknotens C und $p_1, p_2, ... p_{d_c}$ Permutationen über die Menge S sind,
    wobei die Dekodiervorrichtung zumindest einen Prozessor aufweist, der zum Implementieren von zumindest einer Dekodieriteration für mindestens eine Verbindung zwischen den nicht binären variablen Knoten $V_j$, $1 \le j \le d_c$, und dem nicht binären Zwangsknoten C konfiguriert ist, die das Senden einer Nachricht von dem nicht binären Zwangsknoten C an den nicht binären variablen Knoten $V_j$ umfasst,
    wobei die Nachricht aufweist:

    - $n_R$ Zuverlässigkeitsmaßnahmen, die für $n_R$ Kandidatensymbole erhalten haben, die durch den nicht binären variablen Knoten $V_j$ oder durch einen ersten Kompressionsblock ausgewählt werden, der zwischen dem nicht binären variablen Knoten $V_j$ und dem nicht binären Zwangsknoten C implementiert wird, wobei in die $n_R$ Kandidatensymbole als $n_R$ angeforderte Symbole bezeichnet werden,
    - $n_B$ Zuverlässigkeitsmaßnahmen, die für $n_B$ Kandidatensymbole erhalten werden, die von dem nicht binären Zwangsknoten C oder von einem zweiten Kompressionsblock ausgewählt werden, der zwischen dem nicht binären Zwangsknoten C und dem nicht binären variablen Knoten $V_j$ implementiert werden, wobei die $n_B$ Kandidatensymbole als $n_B$ beste Symbole bezeichnet werden,

    mit $1 \le n_B < q$, $1 \le n_R < q$ und $n_R + n_B < q$.

15. Ein Computerprogramm mit Anweisungen zur Durchführung eines Verfahrens nach Anspruch 1, wenn dieses Programm von einem Prozessor ausgeführt wird.

**Revendications**

1. Procédé de décodage d'un mot de code,

    ledit mot de code étant obtenu par mise en oeuvre d'un code comprenant au moins un noeud de contrainte non binaire C sur un ensemble S de cardinalité q > 2 défini à partir d'une matrice de contrôle de parité $\mathbf{H_C}$ du noeud de contrainte non binaire C par l'équation $\mathbf{H_C} \cdot (p_1(V_1), p_2(V_2), ... , p_{d_c}(V_{d_c})^T = 0$, où $V_1, V_2, ..., V_{d_c}$ sont un sous-ensemble de noeuds variables non binaires du mot de code impliqué dans le noeud de contrainte non binaire C, avec $d_c > 2$ le degré de connectivité du noeud de contrainte non binaire C et $p_1, p_2, \ldots p_{d_c}$ sont des permutations sur l'ensemble S,

dans lequel ledit procédé de décodage met en oeuvre, pour au moins une connexion entre le noeud variable non binaire $V_j$, $1 \leq j \leq d_c$, et le noeud de contrainte non binaire $C$, au moins une itération de décodage comprenant l'envoi (21) d'un message du noeud de contrainte non binaire $C$ au noeud variable non binaire $V_j$, ledit message comprenant :

- $n_R$ mesures de fiabilité obtenues pour $n_R$ symboles candidats sélectionnés par le noeud variable non binaire $V_j$ ou par un premier bloc de compression mis en oeuvre entre le noeud variable non binaire $V_j$ et le noeud de contrainte non binaire C, lesdits $n_R$ symboles candidats étant désignés $n_R$ symboles demandés,
- $n_B$ mesures de fiabilité obtenues pour $n_B$ symboles candidats sélectionnés par le noeud de contrainte non binaire C ou par un second bloc de compression mis en oeuvre entre le noeud de contrainte non binaire C et le noeud variable non binaire $V_j$, lesdits $n_B$ symboles candidats étant désignés $n_B$ meilleurs symboles,

avec $1 \leq n_B < q$, $1 \leq n_R < q$ et $n_R + n_B < q$.

2. Procédé selon la revendication 1, dans lequel lesdits $n_R$ symboles demandés sont sélectionnés comme étant les $n_R$ symboles les plus fiables à partir d'au moins l'un de :

- un message intrinsèque obtenu à partir de l'observation de canal,
- un message de probabilité *a posteriori*,
- un message du noeud variable non binaire $V_j$ au noeud de contrainte non binaire C.

3. Procédé selon l'une quelconque des revendications 1 ou 2, dans lequel lesdits $n_B$ meilleurs symboles sont sélectionnés comme étant les $n_B$ symboles les plus fiables à partir d'un message extrinsèque émis par le noeud de contrainte non binaire C.

4. Procédé selon l'une quelconque des revendications 1 à 3, dans lequel ledit message envoyé du noeud de contrainte non binaire C au noeud variable non binaire $V_j$ comprend également les $n_B$ meilleurs symboles.

5. Procédé selon l'une quelconque des revendications 1 à 4, dans lequel ladite au moins une itération de décodage comprend en outre la transmission d'un message du noeud variable non binaire $V_j$ au noeud de contrainte non binaire C, comprenant :

- la génération d'un message $M_{V_j2C}$ comprenant des mesures de fiabilité obtenues pour les q symboles candidats de l'ensemble S,
- la sélection à partir du message $M_{V_j2C}$, par le premier bloc de compression $\Omega$, de $n_{vc}$ symboles candidats et la génération d'un message $\Omega(M_{V_j2C})$ comprenant les $n_{vc}$ symboles et les mesures de fiabilité obtenues pour lesdits $n_{vc}$ symboles,
- la sélection, par le premier bloc de compression $\Omega$, des $n_R$ symboles demandés à partir du message $M_{V_j2C}$, et l'envoi d'un message $M^{R,\oplus}$ à un second bloc de décompression $\Gamma^{-1}$, comprenant les $n_R$ symboles demandés,
- la permutation des $n_{vc}$ symboles du message $\Omega(M_{V_j2C})$, délivrant un message $\Omega\left(M^P_{V_j2C}\right)$, et des $n_R$ symboles demandés, délivrant un message $M^{P,R,\oplus}$,
- la reconstruction, par un premier bloc de décompression $\Omega^{-1}$, d'un message $\Omega^{-1}\left(\Omega\left(M^P_{V_j2C}\right)\right)$ comprenant les $n_{vc}$ symboles, les mesures de fiabilité obtenues pour lesdits $n_{vc}$ symboles, les $q - n_{vc}$ symboles restants, et les mesures de fiabilité réglées à une valeur par défaut pour les $q - n_{vc}$ symboles restants,
- la transmission au second bloc de compression $\Gamma$ du message $M^{P,R,\oplus}$, comprenant les $n_R$ symboles demandés après la permutation.

6. Procédé selon la revendication 5, dans lequel ledit message envoyé du noeud de contrainte non binaire C au noeud variable non binaire $V_j$ est envoyé lorsque le noeud de contrainte non binaire C a reçu des messages $M^P_{V2C}$ en provenance de tous les noeuds variables non binaires connectés au noeud de contrainte non binaire C, et est obtenu à partir de :

- la génération, à partir des messages $M_{V2C}^P$ reçus, $k \neq j$, d'un message $M_{C2V_j}^P$, comprenant des mesures de fiabilité obtenues pour les q symboles candidats de l'ensemble $S$,

- la sélection à partir du message $M_{C2V}^P$, par le second bloc de compression $\Gamma$, des $n_B$ meilleurs symboles et la génération d'un message $M_{C2V_j}^{P,B}$ comprenant les $n_B$ meilleurs symboles et les mesures de fiabilité obtenues pour lesdits $n_B$ meilleurs symboles,

- l'obtention, à partir du message $M_{C2V_j}^P$, des mesures de fiabilité des $n_R$ symboles demandés après la permutation reçues par le second bloc de compression $\Gamma$ dans le message $M^{P,R,\oplus}$,

- la génération d'un message $\Gamma\left(M_{CV_j}^P\right)$ comprenant le message $M_{C2V_j}^{P,B}$ et les mesures de fiabilité des $n_R$ symboles demandés après la permutation,

- la permutation inverse des $n_B$ meilleurs symboles du message $\Gamma\left(M_{C2V_j}^P\right)$, délivrant un message $\Gamma\left(M_{C2V_j}\right)$,

- la reconstruction, par le second bloc de décompression $\Gamma^{-1}$, d'un message $\Gamma^{-1}(\Gamma(M_{C2V_j}))$ comprenant les $n_B$ meilleurs symboles, les mesures de fiabilité obtenues pour lesdits $n_B$ meilleurs symboles, les $n_R$ symboles demandés, les mesures de fiabilité obtenues pour lesdits $n_R$ symboles demandés, les $n_D$ symboles restants et les mesures de fiabilité obtenues pour lesdits $n_D$ symboles restants réglées à une valeur par défaut $S_D$.

7. Procédé selon l'une quelconque des revendications 1 à 6, dans lequel la mesure de fiabilité obtenue pour au moins un desdits $n_R$ symboles demandés est réglée à une valeur par défaut $S_R$ lorsque ladite mesure de fiabilité est au-dessus d'un seuil.

8. Procédé selon l'une quelconque des revendications 1 à 7, dans lequel ledit noeud de contrainte non binaire met en oeuvre une fonction de décodage appartenant au groupe comprenant :

  - une fonction Min-Max,
  - une fonction MinSum étendue,
  - une fonction MinSum étendue en treillis,
  - une fonction de décodage de troncature basée sur un seuil,
  - une fonction de propagation de croyance,
  - une mise en oeuvre dans le domaine de Fourier d'une fonction de propagation de croyance,
  - une fonction avant/arrière.

9. Procédé selon l'une quelconque des revendications 1 à 8, dans lequel le noeud de contrainte non binaire est un noeud de contrôle de parité avec un degré de connectivité $d_v$ donné comme $p_1(V_1) + p_2(V_2) + \cdots + p_{d_c}(V_{d_c}) = 0$ sur l'ensemble S.

10. Procédé selon l'une quelconque des revendications 1 à 8, dans lequel le noeud de contrainte non binaire est un code convolutif.

11. Procédé selon l'une quelconque des revendications 1 à 10, dans lequel le code appartient au groupe comprenant :

  - un code LDPC,
  - un code polaire,
  - un turbo-code.

12. Procédé selon l'une quelconque des revendications 1 à 11, dans lequel le message envoyé du noeud de contrainte non binaire $C$ au noeud variable non binaire $V_j$ comprend une fiabilité de symbole par défaut associée aux $n_D$ symboles restants qui n'appartiennent pas à l'ensemble de $n_B$ meilleurs symboles ni à l'ensemble de $n_R$ symboles demandés.

13. Procédé selon l'une quelconque des revendications 1 à 12, dans lequel le message envoyé du noeud de contrainte non binaire $C$ au noeud variable non binaire $V_j$ comprend au plus $n_B + n_R + 1$ mesures de fiabilités.

14. Dispositif de décodage d'un mot de code,

ledit mot de code étant obtenu par mise en oeuvre d'un code comprenant au moins un noeud de contrainte non binaire $C$ sur un ensemble $S$ de cardinalité q > 2 défini à partir d'une matrice de contrôle de parité $H_c$ du noeud de contrainte non binaire $C$ par l'équation $H_c.(p_1(V_1),p_2(V_2), ...,p_{d_c}(V_{d_c}))^T = 0$, où $V_1,V_2, ... ,V_{d_c}$ sont un sous-ensemble de noeuds variables non binaires du mot de code impliqué dans le noeud de contrainte non binaire $C$, avec $d_c$ > 2 le degré de connectivité du noeud de $p_1$, $p_2$, ... $p_{d_c}$ contrainte non binaire $C$ et sont des permutations sur l'ensemble $S$,
dans lequel ledit dispositif de décodage comprend au moins un processeur configuré pour mettre en oeuvre, pour au moins une connexion entre le noeud variable non binaire $V_j$, $1 \leq j \leq d_c$, et le noeud de contrainte non binaire $C$, au moins une itération de décodage comprenant l'envoi d'un message du noeud de contrainte non binaire $C$ au noeud variable non binaire $V_j$,
ledit message comprenant :

- $n_R$ mesures de fiabilité obtenues pour $n_R$ symboles candidats sélectionnés par le noeud variable non binaire $V_j$ ou par un premier bloc de compression mis en oeuvre entre le noeud variable non binaire $V_j$ et le noeud de contrainte non binaire $C$, lesdits $n_R$ symboles candidats étant désignés $n_R$ symboles demandés,
- $n_B$ mesures de fiabilité obtenues pour $n_B$ symboles candidats sélectionnés par le noeud de contrainte non binaire $C$ ou par un second bloc de compression mis en oeuvre entre le noeud de contrainte non binaire $C$ et le noeud variable non binaire $V_j$, lesdits $n_B$ symboles candidats étant désignés $n_B$ meilleurs symboles,

avec $1 \leq n_B < q$, $1 \leq n_R < q$ et $n_R + n_B < q$.

15. Programme informatique comportant des instructions pour mettre en oeuvre un procédé selon la revendication 1 lorsque ce programme est exécuté par un processeur.

Fig. 1A

Fig. 1B

Fig. 1C

$$M_{V_j 2 C_i}(LLR(n_B), LLR(n_R))$$

21

## Fig. 2

$(n^+, n^\oplus) = (q, 0)$ $\downarrow I_j$

$V_j$

$(q, 0)$ $(q, 0)$

$\Omega$ $\Gamma^{-1}$

$(n_{vc}-1, n_{vc})$ $(0, n_R)$ $(n_B - 1 + n_R, n_B)$

$h_{ij} \rightarrow \otimes$ $\otimes \leftarrow h_{ij}^{-1}$

$(n_{vc}-1, n_{vc})$ $(0, n_R)$ $(n_B - 1 + n_R, n_B)$

$\Omega^{-1}$ $\Gamma$

$(q, 0)$ $(q, 0)$

$+$ $C_i$

## Fig. 3A

$$I = [7, 1, 12, 4, 18, 9, 0, 8]$$

$$V \quad \boxed{=} \quad M_{V2C_{i+1}} = [9, 0, 9, 6, 20, 4, 1, 10]$$

$$[\alpha^{-\infty}, \alpha^0, \alpha^1, \alpha^2, \alpha^3, \alpha^4, \alpha^5, \alpha^6]$$
$$M_{V2C} = [7, 1, 12, 4, 18, 9, 0, 8]$$

$$[\alpha^{-\infty}, \alpha^0, \alpha^1, \alpha^2, \alpha^3, \alpha^4, \alpha^5, \alpha^6]$$
$$\Gamma^{-1}(\Gamma(M_{C2V})) = [7, 4, 2, 7, 7, 0, 6, 7]$$

$$\boxed{\Omega} \longrightarrow \boxed{\Gamma^{-1}}$$
$$M^{R\oplus} = [\alpha^5, \alpha^0]$$

$$\Omega(M_{V2C}) = [(-, \alpha^5), (1, \alpha^0), (4, \alpha^2)] \qquad \Gamma(M_{C2V}) = [(-, \alpha^4), (2, \alpha^1) \mid (8, -), (4, -)]$$
$$\uparrow \qquad\qquad\qquad\qquad\qquad\qquad\qquad\qquad\qquad\qquad\qquad \uparrow \qquad\qquad \uparrow$$
$$0 \qquad\qquad\qquad\qquad\qquad\qquad\qquad\qquad\qquad\qquad\qquad\qquad\qquad\quad \alpha^5 \qquad \alpha^0$$

$$h = \alpha^1 \longrightarrow \otimes \qquad\qquad \otimes \longleftarrow h^{-1} = \alpha^{-1} = \alpha^6$$

$$\Omega(M_{V2C}^P) = [(-, \alpha^6), (1, \alpha^1), (4, \alpha^3)] \qquad \Gamma(M_{C2V}^P) = [(-, \alpha^5), (2, \alpha^2) \mid (8, -), (4, -)]$$
$$\uparrow \qquad\qquad\qquad\qquad\qquad\qquad\qquad\qquad\qquad\qquad\qquad \uparrow \qquad\qquad \uparrow$$
$$0 \qquad\qquad\qquad\qquad\qquad\qquad\qquad\qquad\qquad\qquad\qquad\qquad\qquad\quad 0 \qquad\qquad \alpha^6 \qquad \alpha^1$$

$$\boxed{\Omega^{-1}} \longrightarrow \boxed{\Gamma}$$
$$M^{P, R\oplus} = [\alpha^6, \alpha^1]$$

$$\Omega^{-1}(\Omega(M_{V2C}^P)) = [\infty, \infty, 1, \infty, 4, \infty, \infty, 0] \qquad M_{C2V}^P = [12, 9, 4, 2, 11, 10, 0, 8]$$

$$\boxed{+} \quad C$$

## Fig. 3B

## Fig. 4

Fig. 5

Fig. 6

Fig. 7

Fig. 8

Information vector **I**

| I(1) | I(2) | | I(i) | | I(k) |

Redundancy vector **R1**

| R1(1) | R1(2) | | R1(k) |

Redundancy vector **R2**

| R2(1) | R2(2) | | R2(k) |

$M_{C12I(j)}$

$\Pi$

C1    C2

Fig. 9

101

C — + — A

E

D — = — B

102

Fig. 10

111

M

112

P

113

Pg

Fig. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3637622 A1
- EP 3316486 A1

**Non-patent literature cited in the description**

- **B. SHAMS ; D. DECLERCQ ; V. HEINRICH.** Non-binary split LDPC codes defined over finite groups. *6th International Symposium on Wireless Communication Systems, Siena, Italy,* 2009, 493-497
- **D. DECLERCQ ; M. FOSSORIER.** Decoding Algorithms for Non-Binary LDPC Codes Over GF(q). *IEEE Transactions on Communications,* 2007, vol. 55 (4), 633-643
- **E. LI ; F. GARCIA-HERRERO ; D. DECLERCQ ; K. GUNNAM ; J. O. LACRUZ ; J. VALLS.** Low Latency T-EMS Decoder for Non-Binary LDPC codes. *Asilomar Conference on Signals, Systems and Computers,* 2013, 831-835
- **J. TIAN ; S. SONG ; J. LIN ; Z. WANG.** Efficient T-EMS Based Decoding Algorithms for High-Order LDPC Codes. *IEEEAccess,* 2019, vol. 7, 50 980-50 992
- **V. SAVIN.** Min-Max decoding for non binary LDPC codes. *IEEE International Symposium on Information Theory,* 2008, 960-964
- **L. BARNAULT ; D. DECLERCQ.** Fast Decoding Algorithm for LDPC over GF(2q). *The Proc. 2003 Inform. Theory Workshop, Paris, France,* March 2003, 70-73
- **E. BOUTILLON ; L. CONDE-CANENCIA.** Simplified check node processing in nonbinary LDPC decoders. *2010 6th International Symposium on Turbo Codes Iterative Information Processing,* 2010, 201-205
- **C. MARCHAND ; E. BOUTILLON ; H. HARB ; L. CONDE-CANENCIA ; A. AL GHOUWAYEL.** Hybrid Check Node Architectures for NB-LDPC Decoders. *IEEE Transactions on Circuits and Systems I: Regular Papers,* 2019, vol. 66 (2), 869-880
- **DESIGN OF LOW-COMPLEXITY CONVOLUTIONAL CODES OVER GF(Q ; R. KLAIMI ; C. ABDEL NOUR ; C. DOUILLARD ; J. FARAH.** *2018 IEEE Global Communications Conference (GLOBECOM), Abu Dhabi, United Arab Emirates,* 2018, 1-7